(19) Europäisches Patentamt
European Patent Office
Office européen des brevets

(11) **EP 3 021 126 B1**

(12) **EUROPÄISCHE PATENTSCHRIFT**

(45) Veröffentlichungstag und Bekanntmachung des Hinweises auf die Patenterteilung:
**26.02.2020  Patentblatt 2020/09**

(21) Anmeldenummer: **14003826.6**

(22) Anmeldetag: **13.11.2014**

(51) Int Cl.:
***G01R 15/18*** *(2006.01)*

(54) **Verfahren und Vorrichtung zur potentialgetrennten Strommessung**

Method and device for potential-isolated current measurement

Procédé et dispositif de mesure du courant isolé galvaniquement

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**18.05.2016  Patentblatt 2016/20**

(73) Patentinhaber: **grey BEAR Sagl**
**6616 Losone (CH)**

(72) Erfinder: **Bühler, Ernst**
**CH-6616 Losone (CH)**

(56) Entgegenhaltungen:
**US-A- 5 196 784      US-A- 5 815 391**
**US-A1- 2009 015 184**

EP 3 021 126 B1

**Beschreibung**

Die Erfindung betrifft ein Verfahren und eine Vorrichtung für eine potentialfreie Strommessung in leistungselektronischen Schaltungen und an elektrischen Einrichtungen aller Art nach den Oberbegriffen der Ansprüche 1 und 11.

Problemstellung:

Moderne hochdynamische Regelkreise in leistungselektronischen Schaltungen, verlangen zuverlässige Stromsensoren mit entsprechend hoher Dynamik. Gefragt sind potentialgetrennte, langzeitstabile Stromsensoren mit möglichst weitem Messbereich, welche über eine Bandbreite von Gleichstrom bis in den zweistelligen MHz- Bereich verfügen.

Für Strommessungen an elektrischen Einrichtungen werden, beispielsweise zum Zwecke der Qualitätssicherung, der Erfassung der Wirkleistung, der reaktiven Leistung, der Gleichstromkomponenten, der harmonischen Oberwellen und leitergebunden Störungen prinzipiell die gleichen Anforderungen gestellt.

Das Idealbild wäre ein fiktiver Gleichstromtransformator, welcher über eine beliebig große Bandbreite verfügte, und auch Wechselströme messen könnte. Die Systemrelevanten Parameter sollten sich dabei auf ein Strom- Übersetzungsverhältnis und einen Präzisionswiderstand beschränken.

Bekannte Lösungen für potentialgetrennte Stromsensoren können diese radikalen Anforderungen nicht erfüllen.

Stand der Technik:

Für hochdynamische Regelkreise, hat man schon im Jahr 1984 Messwiderstände in spezieller Streifenleiter- Anordnung entwickelt, welche in gedruckte Leiterplatten eingebaut werden konnten. In Impulsgeneratoren für die funkenerosive Bearbeitung wurden über Jahrzehnte erfolgreich Sensoren nach der Patentschrift DE 34 05 442, Bühler et al, für die Echtzeit- Stromimpulsform- Regelung eingesetzt. Das Grundprinzip ist in Fig. 2 als Stand der Technik dokumentiert. In dieser Schrift ist eine theoretische obere Grenzfrequenz fo von 624MHz angegeben. Die untere Grenzfrequenz entspricht bei der rein ohmschen Messmethode 0Hz, oder Gleichstrom.

Leider hat diese Lösung zwei große Nachteile: erstens gibt es keine Potentialtrennung und zweitens können die Verluste in den Widerstandsstreifen 4, 5 derart hoch werden, dass eine aufwändige Kühlung benötigt wird.

Der erste Nachteil ist weniger gravierend, da es auch möglich ist, nur die normalerweise niederdynamischen Sollwerte auf die Leistungselektronik isoliert zu übertragen, um dann die Regelkreise lokal zu schließen.

Der zweite Nachteil ist physikalischer Natur und kann nicht so leicht umgangen werden. Um Messsignale hoher Bandbreite störsicher bereitzustellen, braucht es eine minimale Spannung U über einem Messwiderstand R von etwa 10mV.

Der in der Patentschrift DE 34 05 442 angegebene typische Wert für den Messwiderstand, R = 40mΩ, ergibt bei einem angenommenen Nennstrom I von 25A eine unangenehm hohe Verlustleistung Pd von:

$$Pd = I^2 * R = 25^2 * 0.040 = 25W \qquad und: U = I * R = 25 * 0.040 = 1V$$

Bei einer angenommenen, zwei Dekaden tieferen Stromuntergrenze von I = 0.25A ergäbe sich ein minimales Messsignal U am unteren Limit von:

$$U = I * R = 0.25 * 0.040 = 10mV \qquad und: Pd = I^2 * R = 0.25^2 * 0.040 = 2.5mW$$

Je weiter der Messbereich ausgedehnt werden soll, umso ungünstiger werden die Verhältnisse zwischen maximaler Verlustleistung Pd und minimalem Messsignal U bei kleinen Strömen.

Es sind zahlreiche Lösungen zur potentialfreien Messung von elektrischen Strömen bekannt, aber alle heute gebräuchlichen Messprinzipien haben ihre spezifischen Nachteile.

Rogowski Coil: hat eine eisenlose Spule um den Stromleiter, braucht einen Integrator um das Messsignal zu bilden und ist deshalb nur für Wechselstrom geeignet. Die notwendige, individuelle Kalibrierung ist kostenintensiv. Dieser Sensor kann je nach Anforderungen sehr teuer und voluminös sein.

Hall- Effekt Closed- Loop- Stromwandler: Der Stromtransformator mit Magnetsensor und Kompensationswicklung für die Gleichstromkomponente, ist aufwändig in der Herstellung, auf 0 bis etwa 200kHz Bandbreite beschränkt, mit Reaktionszeiten um 500ns behaftet, und empfindlich auf statische und dynamische Magnetfelder.

Hall- Effekt Open- Loop- Stromwandler: Der Stromtransformator mit Magnetsensor und Integrierter Schaltung zur Temperatur- und Linearitätskompensation, ist zwar günstiger herstellbar, aber auf eine Bandbreite von 0 bis 50kHz beschränkt, mit Reaktionszeiten um 3μs behaftet, empfindlich auf statische und dynamische Magnetfelder, sowie problematisch in der Langzeitstabilität.

Flux- Gate Kompensations- Stromwandler: brauchen eine Anregungsfrequenz um die Kern- Magnetisierung erfassen und kompensieren zu können. Diese Anregungsfrequenz wird auch teilweise im Messsignal abgebildet. Flux-Gate Stromwandler sind besser in der Temperatur- und Langzeitstabilität, haben eine Bandbreite von 0 bis etwa 200kHz, sind mit Reaktionszeiten um 300ns behaftet, und ebenfalls auf statische und dynamische Magnetfelder empfindlich.

Netzfrequenz- Stromwandler: haben eine Bandbreite von lediglich 50 bis 400Hz und sind groß in der Bauform und schwer im Gewicht. Sie sind weder für Gleichstrom noch hohe Frequenzen brauchbar.

US 5 815 391, Pelly: offenbart Stromsensoren nach dem Wechselstrom-Transformatorprinzip und, alternativ nach dem Rogowski- Coil- Prinzip. Die Steuersignale der Pulsweiten- Modulation (PWM) eines Inverters dienen gleichzeitig zur synchronen Auswertung des sekundären Messstromes bzw. zum synchronen Rücksetzen des Integrators eines Stromsensors nach dem Rogowski- Coil- Prinzip. Die Schaltelemente der Brückenzweige erfüllen zusätzlich zu ihrer Hauptaufgabe, der Strommodulation, die Aufgabe der periodischen Stromunterbrechung in den Wechselstrom-Transformatoren, und damit die Definition des Nullstrom- Niveaus, sowie der Entladung der magnetischen Energie.

Der Stromsensor ist jedoch mit einer Vielzahl von Nachteilen behaftet. Die zwingende Anordnung der Stromsensoren in den Querzweigen des Inverters führt erstens zu erheblichen Störungen des Messstromes durch Stromspitzen während der Sperrverzugszeit der Freilaufdioden, und zweitens zu Lücken des Messstromes während einer Sicherheitszeit zwischen der Aktivierung des oberen und des unteren Schaltelementes.

Die PWM- Signale müssen drittens primär auf die Auslegung des Inverters optimiert sein, was typischerweise den Anforderungen der Stromsensoren zuwiderläuft.

Viertens führen extreme Tastverhältnisse der PWM- Signale nahe 100% wegen Sättigung der Magnetkreise zum Versagen der Stromsensoren.

Als fünfter Nachteil muss erwähnt werden, dass die räumliche Verteilung der relevanten stromführenden Elemente (IGBT, Freilauf- Diode und Stromsensor) eine Echtzeitabbildung des Phasenstromes infolge der parasitären Einschwingeffekte verunmöglicht. Die Bandbreite und die Betriebssicherheit werden dadurch stark eingeschränkt, und Störfälle wie Kurzschlüsse, oder Erdschlüsse können nicht zuverlässig beherrscht werden.

US 5 196 784, Estes: offenbart einen speziellen Stromsensor zur Erfassung von Gleichstrom und Strömen mit hohem Tastverhältnis in elektrischen Antrieben für Steuerruder von Raketen. Prinzipiell wird während einer Messpause in die Sekundärwicklung eines Stromtransformators ein Anti- Sättigungsstrom eingeprägt. Dieser Sekundärstrom sättigt den Magnetkern in Gegenrichtung des Feldes, welches der Primärstrom verursacht. Die Messpause kann mit einer Sample & Hold- Schaltung (S&H) überbrückt werden.

Eine Tandemanordnung zweier Sensoren soll eine fast lückenfreie Erfassung des Stromes ermöglichen. Die immer verbleibenden Lücken sowie Schwingungen infolge parasitärer Effekte müssen elektronisch ausgefiltert werden.

Diese Lösung ist mit teils gravierenden Nachteilen behaftet.

Der Sensor kann prinzipiell nur monopolare Stromimpulse oder Gleichströme messen.

Die Kerne der Stromtransformatoren müssen eine rechteckförmige Magnetisierungskurve, und eine hohe Sättigungs- Flussdichte aufweisen. Die vorgeschlagenen, gewickelten Magnetkerne aus Feinstblech einer Nickel-Eisen-Legierung könnten zwar solche Anforderungen erfüllen, es resultiert aber eine bescheidene Bandbreite und hohe Kernverluste.

Das Hauptproblem ist das Antisättigungsprinzip an sich, welches zwingend verlangt, dass der Anti- Sättigungsstrom mindestens größer als der sekundäre Messstrom sein muss. Ein Überlaststrom führt demnach entweder zum Ausfall des Stromsensors, oder bei entsprechender Überdimensionierung des Anti-Sättigungsstromes zu exzessivem Leistungsbedarf der Sensorelektronik. Werden Messlücken und Störsignale mit S&H- Schaltungen oder Filter korrigiert, können entweder zufällige, schnelle Stromexkursionen nicht sicher erfasst werden, oder die Bandbreite des Stromsensors würde noch eine zusätzliche Reduktion erleiden.

US 2009/0015184, Knierim: offenbart ein Strommessverfahren und Vorrichtungen für die Regelung kleinerer Dreiphasen- Motoren. Mit einer bestimmten sequenziellen Verzögerung am Anfang der PWM- Signale des Inverters, ist es möglich mit nur einem Stromsensor zwei Brückenzweigströme zu messen, und daraus alle Phasenströme in einem Digitalen Signal- Prozessor (DSP) zu berechnen. Die Sekundärwicklung des Stromtransformators wird über einen bidirektionalen Fluss- Reset- Schalter auf einen Messwiderstand geführt. Geöffnet wird der Fluss- Reset- Schalter nur während einer ersten Periode, wo alle oberen Schaltelemente der Brücke per Definition "nicht leitend" geschaltet sind, was die Entmagnetisierung des Magnetkreises bewirkt.

Am Anfang einer zweiten Periode wird das obere Schaltelement eines ersten Brückenzweiges und der Fluss-Reset- Schalter eingeschaltet und die Spannung am Messwiderstand über einen Analog / Digital- Wandler ausgelesen. Während einer dritten Periode wird der zweite Brückenzweig zugeschaltet und genau gleich vorgegangen. Aus diesen Daten berechnet der DSP alle Phasenströme und die zukünftigen Tastverhältnisse für die Brückenzweige.

Das Funktionsprinzip des Stromsensors ist offensichtlich gleich, wie jenes der US 5 815 391. Die dort aufgeführten Nachteile gelten entsprechend auch für die US 2009/0015184.

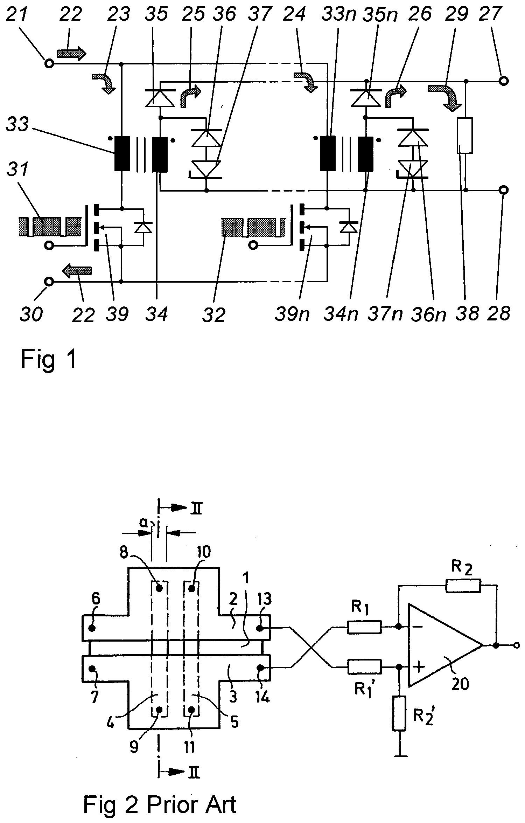

Infolge einer einzigen Abtastung während 50$\mu$s im Beispiel der Fig. 2, ist nach dem Abtasttheorem von Nyquist / Shannon, die maximale Bandbreite der Strommessung mit 10kHz sehr eingeschränkt.

<u>Aufgabe:</u>

Der Erfindung liegt die Aufgabe zugrunde, ein neuartiges Messprinzip zur Erfassung elektrischer, monopolarer und bipolarer Ströme vorzuschlagen, welches die erwähnten Nachteile bekannter Stromsensoren nicht aufweist.

Insbesondere soll der Sensor über eine große Bandbreite, von Gleichstrom bis in den zweistelligen MHz-Bereich verfügen, und bei Stromimpuls- Tastverhältnissen von 0% bis 100% zuverlässig messen können.

Weiter sollen die Verluste so tief sein, dass keine voluminösen Kühleinrichtungen erforderlich sind. Der Stromsensor soll kurzzeitig überlastbar sein und über mehrere Dekaden im Strombereich skalierbar sein, ohne dass sich dabei die Messgenauigkeit verschlechtert oder die maximale Verlustleistung übermäßig erhöht wird.

Der Stromsensor soll sich sowohl zur direkten Integration in leistungselektronische Schaltungen, als auch als diskretes Modul eignen.

Die Rückwirkungen auf die Leistungselektronik und die Streukapazitäten zur Steuerelektronik müssen vernachlässigbar sein. Unempfindlichkeit auf statische und dynamische Störfelder, gute Linearität, Temperatur- Unabhängigkeit, eine gute Langzeitstabilität, sowie eine geringe Leistungsaufnahme der Sensorelektronik sind weitere wichtige Forderung.

<u>Erfindung:</u>

Die erfindungsgemässe Lösung vereinfacht, respektive ermöglicht erst viele Anwendungen der Leistungselektronik, wo schnellste Reaktionen auf Sollwertabweichungen in zeitkritischen Regelschleifen verlangt werden.

Vorgeschlagen wird ein neuartiges Verfahren für eine potentialfreie Strommessung in leistungselektronischen Schaltungen und an elektrischen Einrichtungen gemäß Anspruch 1, dadurch gekennzeichnet, dass ein zu messender Strom unterbruchsfrei und zeitweise aufgeteilt über mehrere parallele Pfade der Strommessung geführt wird, und dass die Pfade aus einer Serieschaltung von Schaltelementen mit Primärwicklungen von Stromtransformatoren oder von einem Bypass- Schaltelement gebildet sind, und dass in Sekundärwicklungen induzierte sekundärseitige Teilströme einem Übersetzungsverhältnis der Stromtransformatoren entsprechend, zu einem sekundärseitigen Gesamtstrom summiert und abgebildet und über einen Messanschluss ausgewertet werden, und dass während Unterbruchszeiten der Schaltelemente eine gespeicherte magnetische Energie, der Stromtransformatoren in Spannungs- begrenzende Elemente abgeführt wird.

Weiter wird eine Vorrichtung gemäß Anspruch 11 offenbart für eine potentialfreie Messung von Gleich- oder Wechselstrom bestehend aus Stromtransformatoren und monodirektionale oder bidirektionale Schaltelementen und elektronischen Steuermitteln und Dioden und Spannungs- begrenzenden Elementen und einem Messwiderstand, dadurch gekennzeichnet, dass die Stromtransformatoren primärseitig mit den Schaltelementen eine Serieschaltung bilden, und dass die Serieschaltungen zueinander, oder mit einem Bypass- Schaltelement eine Parallelschaltung bilden, und dass die elektronischen Steuermittel so ausgelegt, und mit den Schaltelementen verbunden sind, dass die Schaltelemente alternierend und zeitweise überlappend eingeschaltet werden, und dass in Sekundärwicklungen induzierte Messströme über die Dioden oder über die sekundären monodirektionalen oder bidirektionalen Schaltelemente auf den Messwiderstand geführt sind, und dass Magnetisierungsströme der Stromtransformatoren in die Spannungs- begrenzenden Elemente überführt werden.

Sämtliche Bauteile des Stromsensors sind auch als oberflächenmontierbare Komponenten (SMD) als Massenware erhältlich. Dadurch sind die erfindungsgemässen Stromsensoren im Vergleich zu bekannten Lösungen besonders preiswert, leicht im Gewicht und klein in der Baugrösse.

Die weitere Ausgestaltung der Erfindung kann den abhängigen Ansprüchen entnommen werden.

<u>Anwendungsgebiet:</u>

Die beschriebenen Verfahren und Stromsensoren können in leistungselektronische Schaltungen integriert werden, oder für breitbandige Messungen an elektrischen Apparaten eingesetzt werden. Besonders vorteilhaft ist die Anwendung für hochdynamische Servoantriebe wie z.B. Linearantriebe in Werkzeugmaschinen oder Robotern. Ein weiteres typisches Einsatzgebiet der Stromsensoren betrifft Impulsgeneratoren für die funkenerosive Bearbeitung (EDM), elektrochemische Bearbeitung (ECM), oder die Laserbearbeitung. Eine andere Anwendung ergibt sich für die Messtechnik allgemein an elektrischen Apparaten, aber z.B. auch eingebaut in Energiezählern oder universellen Messgeräten wie Digitale Multimeter (DMM).

Nachfolgend werden unter Bezugnahme auf die beiliegenden Zeichnungen verschiedene Ausführungsformen der Erfindung näher erläutert. Die Figuren zeigen:

Fig. 1     Das Grundprinzip der Erfindung zur Messung von monopolaren Strömen.

Fig. 2     Eine bekannte Lösung aus der Patentschrift DE 34 05 442 mit bandförmigen Widerstandsstreifen.

Fig. 3     Eine Ausführungsform der Erfindung mit mindestens zwei Stromzweigen.

Fig. 4     Eine vereinfachte Ausführungsform mit einem Stromzweig und einer alternativen externen Aktivierung der Strommessung.

Fig. 5     Eine Ausführungsform mit mindestens zwei Stromzweigen und Colpitts-Oszillator.

Fig. 6     Die Ausführungsform nach Fig. 5 mit einem Energie- Ernter zur Energieversorgung der primärseitigen Steuerelektronik.

Fig. 7     Die vereinfachte Ausführungsform nach Fig. 4 mit Signalkonditionierung und Bereichsumschaltung.

Fig. 8     Die Ausführungsform nach Fig. 3, modifiziert zur Messung von bipolaren Strömen.

Fig. 9a     Messresultate eines Aufbaus nach Fig. 3 bei 10kHz Oszillatorfrequenz und einem Rechteck- Stromimpuls von 560$\mu$s Dauer und 1A Amplitude.

Fig. 9b     Messresultate eines Aufbaus nach Fig. 3 bei 10kHz Oszillatorfrequenz und einem Rechteck- Stromimpuls von 560$\mu$s Dauer und 100A Amplitude.

Fig. 10a     Messresultate eines Aufbaus nach Fig. 3 bei 20kHz Oszillatorfrequenz und einem Rechteck- Stromimpuls von 560$\mu$s Dauer und 1A Amplitude.

Fig. 10b     Messresultate eines Aufbaus nach Fig. 3 bei 20kHz Oszillatorfrequenz und einem Rechteck- Stromimpuls von 560$\mu$s Dauer und 100A Amplitude.

Fig. 11a     Messresultate eines Aufbaus nach Fig. 5 bei 87kHz Colpitts-Oszillatorfrequenz und einem Rechteck- Stromimpuls von 27$\mu$s Dauer und 50A Amplitude.

Fig. 11b     Messresultate eines Aufbaus nach Fig. 5 bei 87kHz Colpitts-Oszillatorfrequenz bei einem Rechteck- Stromanstieg von 210ns Dauer und 20A Amplitude.

Fig. 11c     Messresultate eines Aufbaus nach Fig. 5 bei 87kHz Colpitts-Oszillatorfrequenz bei einem Rechteck- Stromabfall von 38ns Dauer und 20A Amplitude.

Fig. 12     Messresultate eines Aufbaus nach Fig. 8 bei 47kHz Oszillatorfrequenz und einem 50Hz Wechselstrom von 20A Amplitude.

Beschreibung

Das Grundprinzip der Erfindung wird in Fig. 1 mit Pfeilen für die Ströme und Teilströme veranschaulicht. Über den Laststromeingang 21 fließt der primärseitige Gesamtstrom 22 in den Stromsensor und über den Laststromausgang 30 entsprechend vom Stromsensor weg.

Der Gesamtstrom 22 wird in einen ersten primärseitigen Teilstrom 23 und in einen zweiten primärseitigen Teilstrom 24 aufgeteilt. Dies hat zwei proportionale, induzierte Sekundärteilströme 25, 26 zur Folge, welche als summierter sekundärer Gesamtstrom 29 auf dem Messwiderstand 38 eine Spannung an den Messanschlüssen 27, 28 bewirken, welche proportional genau dem primären Gesamtstrom 22 entspricht. Die Bandbreite des Stromsensors erstreckt sich von Gleichstrom bis mehrere 10MHz, dies obschon die zwei Steuersignale 31, 32 die zur Umleitung der primären Teilströme dienen, eine um drei Dekaden tiefere Dynamik aufweisen können.

Die Steuersignale 31, 32 können beispielsweise von einem selbstschwingenden Halbbrücken- Treiberbaustein IR21531S der Firma International Rectifier, USA: www.irf.com erzeugt werden. Wenn man die Spannungsquellen beider Ausgangstreiber parallel schaltet, ergeben sich zwei Rechtecksignale, welche sich nur um 180° in der Phasenlage unterscheiden.

Da die Magnetisierungsströme der Stromtransformatoren 33, 34 und 33n, 34n vom Messwiderstand 38 ferngehalten werden, weist die Spannung an den Messanschlüssen 27, 28 eine definierte und offsetfreie Null- Referenz auf. Das ist ein sehr wichtiger Aspekt der Erfindung, um dem Idealfall eines Gleichstromtransformators möglichst nahe zu kommen.

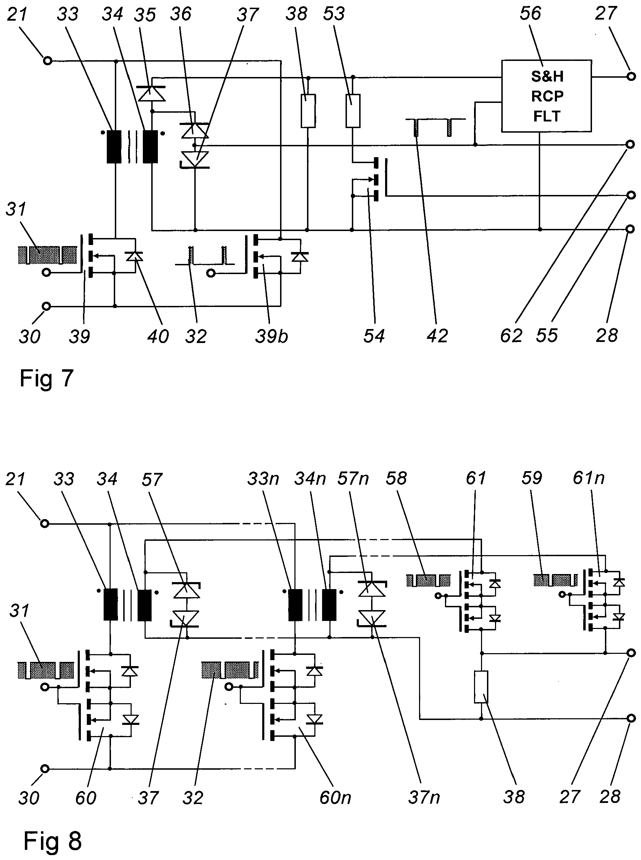

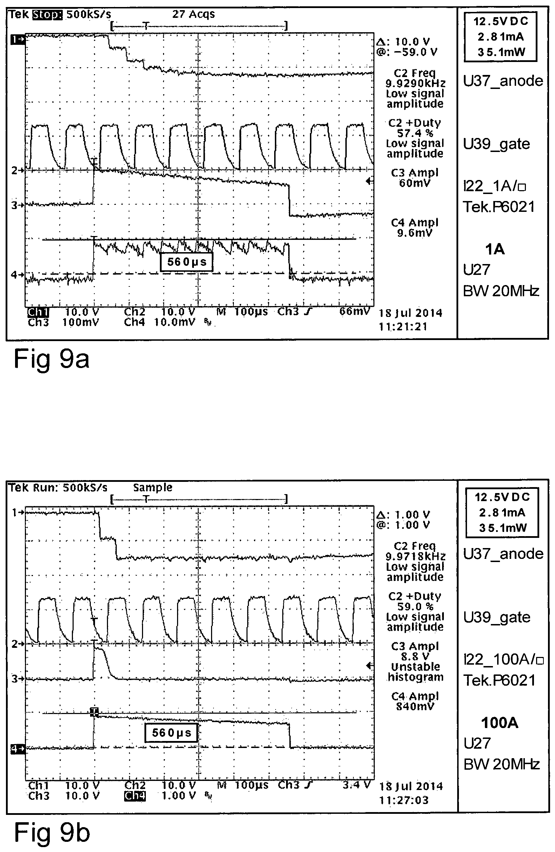

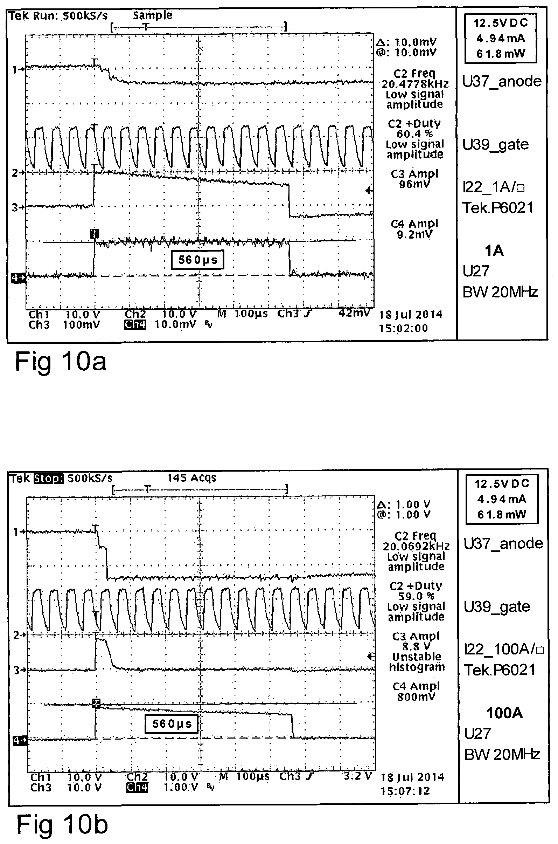

Eine wichtige Dimensionierungsregel sollte jedoch befolgt werden: die Frequenz der Steuersignale 31, 32 sollte nur so tief gewählt werden, dass die Magnetisierungsströme noch keinen erheblichen Betrag eines minimalen sekundären Gesamtstromes 29 ausmachen, (vergleiche Fig. 9a: 10kHz mit Fig.10a: 20kHz). Der Grund dafür ist klar: die rampenförmig ansteigenden Magnetisierungsströme der Stromtransformatoren 33, 34 und 33n, 34n werden von den primären Teilströmen 23, 24 alimentiert, und fehlen entsprechend den sekundären Teilströmen 25, 26. Alternativ könnte man, wie in Fig. 7 dargestellt, eine Ripple- Kompensation 56, RCP vorsehen, um mit einem künstlich erzeugten Korrektursignal den Fehler zu eliminieren.

Die in Fig. 2 aus der Patentschrift DE 34 05 442 wiedergegebene Lösung wurde einleitend diskutiert, und bedarf nur noch einiger Ergänzungen. Die Widerstandsstreifen 4, 5 sind durch eine Isolation 1 von den Kontaktelektroden 2, 3 getrennt und mit Kontaktierungen 8-11 versehen. Das Ziel ist, die parasitären Induktivitäten der Messanordnung durch parasitäre Kapazitäten der Kontaktelektroden 2, 3 zu kompensieren.

Die Stromanschlüsse 6, 7 entsprechen dem Laststrom Ein- und Ausgang 21, 30 der Fig. 1. Zusammen mit den Anschlüssen 13, 14 wird eine sogenannte Kelvin-Verbindung gebildet, welche Spannungsabfälle über den Kontaktierungen 2, 3, 8-11 von der Auswertung im Differenzverstärker 20 weitgehend fernhält.

Diese Maßnahmen führen zu einer großen Bandbreite von Gleichstrom bis Frequenzen über 100MHz, sowie zu einer guten Stabilität der Strommessung. Dennoch ist diese Lösung aus den vorerwähnten Gründen, insbesondere wegen der hohen Verlustleistung und der unakzeptablen Baugrösse, nicht mehr tragbar.

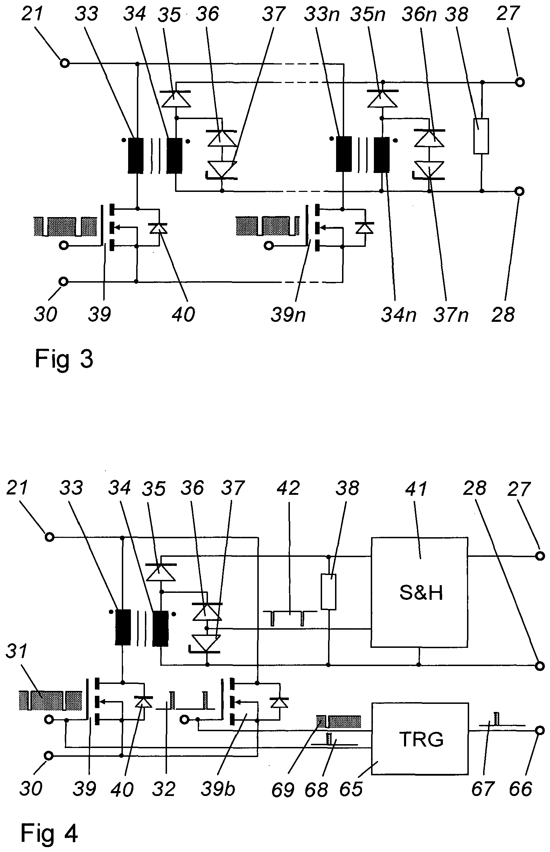

Die Fig. 3 dient der genaueren Beschreibung einer Ausführungsform mit mindestens zwei monopolaren Teilströmen 23, 24. Ein erster Stromtransformator 33, 34 wird über ein erstes Schaltelement 39, ein- und ausgeschaltet. Wenn, wie bevorzugt, MOSFET-Schaltelemente eingesetzt werden, so ist noch eine parasitäre Diode 40 in Gegenstromrichtung vorhanden.

Ein letzter Stromtransformator 33n, 34n wird durch ein letztes Schaltelement 39n typischerweise antizyklisch zu den anderen Stromtransformatoren und / oder überlappend mit diesen ein- und ausgeschaltet.

Die Stromtransformatoren 33, 34 und 33n, 34n können je nach Anwendung, von unterschiedlichster Ausführung sein. Stromtransformatoren mit Kernen aus weichmagnetischem Eisenblech eignen sich nur für Messungen mit bescheidener Bandbreite von 50Hz bis 400Hz. Ein aus Weicheisenband gewickelter Stromtransformator, beispielsweise vom Typ IE 0,5/200 der Firma REO, D: www.reo.de ist schon wegen seiner Baugrösse von 50x50x25mm und seinem Gewicht von 150g völlig ungeeignet um in gedruckten Leiterplatten Verwendung zu finden. Stromtransformatoren mit Ferritkernen können hingegen, je nach Ferritmaterial Frequenzen im mehrstelligen MHz- Bereich übertragen. Ferritkerne weisen aber eine geringere maximale magnetische Flussdichte (Induktion) als Eisenblech auf und müssen daher bei einer höheren Minimalfrequenz betrieben werden um nicht in Sättigung zu gehen.

Für die nachfolgenden Beispiele und Messresultate wurden Produkte PB0026 der Firma Pulse, USA: www.pulseeng.com oder kompatible Produkte B82801C0565A100 der Firma Epcos, D: www.epcos.com eingesetzt. Dieser SMD-Stromtransformator mit einem Übersetzungsverhältnis von 1:100, hat einen Primärstrom von 35A, einen Primärwiderstand von 2.8mΩ, einen Sekundärwiderstand von 1.4Ω, eine Koppelkapazität zwischen Primär- und Sekundärseite von lediglich 4pF und wiegt bei einer Baugrösse von 20x15x10mm nur 4.7g.

Die Schaltelemente 39, 39n, bevorzugt MOSFET- Bauelemente, können aus einer breiten, aktuell verfügbaren Palette ausgewählt werden. Für die Beispiele und nachfolgenden Messresultate wurden Produkte IRFH4201 der Firma International Rectifier, USA: www.irf.com verwendet. Dieses vergleichsweise winzige Bauteil im sogenannten PQFN-Gehäuse von 5x6x0.8mm kann eine Spannung von 25V und einen Strom von 100A schalten. Der Einschaltwiderstand beträgt maximal 0.95mΩ, dies bei einem Steuersignal von 10V und einer Eingangskapazität von typisch 6.1nF. Wird nun ein Stromsensor mit zwei Strompfaden bei einem Nennstrom von 25A im nicht überlappenden Bereich betrieben, ergeben sich Verluste in den Schaltelementen 39 oder 39n von: $Pd = 25^2A * 0.95m\Omega = 593mW$

Im überlappenden Bereich ergeben sich nur noch die halben Verluste von:

$$Pd = 2 * 12.5^2A * 0.95m\Omega = 297mW$$

Wird der Stromsensor mit zwei Strompfaden mit vierfacher Überlast, bei 100A im nicht überlappenden Bereich betrieben, ergeben sich Verluste in den Schaltelementen 39 oder 39n von: $Pd = 100^2A * 0.95m\Omega = 9.5W$

Der 40mΩ- Messwiderstand in Fig. 2 hätte bei 100A vergleichsweise eine Verlustleistung von 400W.

Im überlappenden Betrieb ergeben sich ebenfalls nur die halben Verluste von:

$$Pd = 2 * 50^2A * 0.95m\Omega = 4.75W.$$

Das wirkt sich gleichfalls auf die ohmschen Kupferverluste $Pd_{cu}$ aus. Bei einem äquivalenten Kupferwiderstand auf der Primärseite von 2.94m$\Omega$ und 25A, sind die Kupferverluste ohne Überlappung bei:

$$Pd_{cu} = 25^2A * 2.94m\Omega = 1.84W$$

Bei einem äquivalenten Kupferwiderstand auf der Primärseite von 2.94m$\Omega$ und 25A Nennstrom, sind die Kupferverluste mit Überlappung bei:

$$Pd_{cu} = 2 * 12.5^2A * 2.94m\Omega = 919mW$$

Es ist also durchaus lohnend, den Überlappungsbereich der beiden Strompfade so weit wie möglich auszudehnen.

Addiert man nun für den Nennstrom von 25A ohne Überlappung die verschiedenen Verluste: Schaltelemente 39, 39n (593mW) + Kupferverluste (1.84W) + 1$\Omega$-Messwiderstand 38 (63mW) + Schottky- Diode 25, 35n (125mW) so ergibt sich eine Gesamt- Nennverlustleistung von: 2.62W, d.h. fast Faktor 10 geringer als die bekannte Lösung nach Fig. 2.

Addiert man für den gleichen Nennstrom von 25A, bei 80% Überlappung die verschiedenen Verluste: Schaltelemente 39, 39n (593mW * 0.2 + 297mW * 0.8 = 356mW) + Kupferverluste (1.84W * 0.2 + 919mW * 0.8 = 1.103mW) + 1$\Omega$-Messwiderstand 38 (63mW) + Schottkydiode 35, 35n (125mW) ergibt sich eine Gesamt- Nennverlustleistung von: 1.65W, etwa Faktor 15 geringer als die bekannte Lösung nach Fig. 2.

Um eine hohe Überlappung zu ermöglichen, ist es vorteilhaft für die sekundären Dioden in Stromrichtung 35, 35n Schottky- Dioden zu verwenden, den Messwiderstand 38 niederohmig zu halten und die Zenerdioden 37, 37n mit hoher Spannung vorzusehen, um die Magnetisierungsströme tief zu halten, respektive rasch abzubauen.

Für die Dioden in Sperrrichtung 36, 36n können hingegen auch schnelle Siliziumdioden eingesetzt werden.

An dieser Stelle sei hervorgehoben, dass bei allen Beispielen und denkbaren Ausführungsformen immer nur Durchlassverluste, aber keine Kommutationsverluste in den Schaltelementen 39, 39n, 60, 60n auftreten. Dank dem überlappenden Betrieb und den weichen Schaltvorgängen kann sich keine nennenswerte Spannung aufbauen.

Für die denkbar einfachste Ausführungsform, dargestellt in Fig. 4, mit nur einem Stromzweig, sollte man die vorgenannten Regeln noch strikter beachten. Diese Ausführung hat nämlich einen beobachtungslosen Zeitraum, der natürlich möglichst kurz sein sollte.

Während dem beobachtungslosen Zeitraum wird der Magnetisierungsstrom des Stromtransformators 33, 34 in die Zenerdiode 37, oder in eine Spannungsquelle der Steuerelektronik entladen. Der Teilstrom 24 fließt während dem beobachtungslosen Zeitraum direkt über das Bypass- Schaltelement 39b, ohne in einem Stromtransformator 33n, 34n gemessen zu werden.

Es wäre auch denkbar, den Teilstrom 24 über eine zusätzliche Diode anstelle des Bypass- Schaltelementes 39b zu leiten. Diese Lösung hätte aber mehrere gravierende Nachteile wie: viel höhere Verluste, Verfälschung der Messwerte infolge parasitärer Ströme durch diese Diode während des Messzeitraumes, sowie größer im Volumen und Gewicht und letztlich auch teurer.

Um ein hohes Tastverhältnis für das Steuersignal 31 zu erreichen, ist es ausreichend, dem Zeit- bestimmenden Kondensator des Halbbrücken- Treiberbausteins IR21531S einen Widerstand parallel zu schalten, was die Aufladung des Kondensators verzögert, und die Entladung beschleunigt.

Der Treiberausgang welcher normalerweise einen oberen Brückenschalter ansteuert, liefert nun das invertierte Steuersignal 32 mit sehr tiefem Tastverhältnis um das Bypass- Schaltelement 39b anzusteuern. Auch bei diesem Beispiel muss der Betrieb der Schaltelemente 39, 39b natürlich minimal überlappend sein.

Der sekundärseitige Teil 34, 35, 38, 27, 28 des Stromsensors ist immer mit einem Steuer- oder Regelsystem verbunden, welches schon Speisespannungen bereithält. So kann man auch problemlos eine Sample & Hold- Schaltung 41, S&H dem Messwiderstand 38 nachschalten, um den beobachtungslosen Zeitraum zu überbrücken.

Eine einfache Ausführungsform einer Sample & Hold- Schaltung 41 besteht aus einem MOSFET- oder JFET-Schaltelement. Über das Freigabesignal 42 welches direkt aus der Zenerdiode 37 oder aus der Sekundärwicklung 34 abgeleitet werden kann, wird dann während dem beobachtungslosen Zeitraum das MOSFET- oder JFET-Schaltelement in den nichtleitenden Zustand versetzt. Das Freigabesignal 42 wird bevorzugt über einen ohmschen Spannungsteiler den MOSFET- oder JFET-Schaltelementen zugeführt, dies auch um die Kapazität der Zenerdiode 17 zu entladen. Die parasitären Kapazitäten zwischen den Messanschlüsse 27, 28 sind oft genügend, um den letzten Messwert während dem beobachtungslosen Zeitraum zu erhalten. Allenfalls könnte ein kleiner Kondensator und ein Buffer- Verstärker nachgeschaltet werden.

Einerseits muss klar sein, dass die Ausführungsformen mit einem Strommesszweig nur für Fälle eingesetzt werden dürfen, wo ein kurzer beobachtungsloser Zeitraum zulässig ist. Es sind also insbesondere Anwendungen ausgeschlossen, wo extreme und stochastische Stromexkursionen auftreten können, wie beispielsweise EDM- und ECM-Generatoren im Kurzschlussfall.

Anderseits bringen die Ausführungsformen mit nur einem Strommesszweig zahlreiche Vorteile wie: geringere Komplexität, d.h. höhere Zuverlässigkeit, geringere Kosten, geringste Streukapazität gegen die sekundäre Steuerelektronik, geringste Leistungsaufnahme der Sensorelektronik und kleinste Baugrösse und geringes Gewicht.

In der Fig. 4 ist zusätzlich noch eine interessante Alternative zur Erzeugung der Steuersignale 31, 32 über einen Oszillator- Baustein dargestellt. Eine Auslöseschaltung 65, TRG löst auf ein externes Auslösesignal 67 eine einmalige Strommessung über die Steuerimpulse 68, 69 aus.

Die Mehrzahl der Anwendungen von Stromsensoren sind nämlich rein digital geregelt oder gesteuert, d.h. es werden sequentiell verarbeitende Mikroprozessoren ($\mu$P) oder auch Feld- Programmierbare Logikschaltungen (FPGA) eingesetzt. Generell benötigen solche Systeme die Messwerte nur zu diskreten Zeitpunkten.

Diese Betriebsart invertiert tendenziell die Tastverhältnisse der Steuersignale 31, 32. Das erste Steuerimpuls-Signal 68 wird anstelle des ersten Steuersignals 31 an das Schaltelement 39 angeschlossen. Das zweite Steuerimpuls-Signal 69 wird anstelle des letzten Steuersignals 32 an das Bypass- Schaltelement 39b angeschlossen.

Das Bypass- Schaltelement 39b für den beobachtungslosen Zeitraum bleibt durchschnittlich deutlich länger eingeschaltet als das Schaltelement 39 für den Messzeitraum. Das Messergebnis wird sofort, d.h. nach wenigen 10ns auf dem Messwiderstand 38 abgebildet, und eine Sample & Hold- Schaltung 41, S&H erübrigt sich.

Die $\mu$P- oder FPGA- Systeme können den Triggeranschluss 66 für statistische Auswertungen mehrfach aktivieren, oder während einem entsprechend länger dauernden Messzeitraum mehrfach abtasten. Die maximale Dauer des Messzeitraumes ist natürlich durch die maximale Induktion des Stromtransformators 33, 34 begrenzt, kann aber beispielsweise bis über 20$\mu$s betragen. Außer einer Minimalzeit für den beobachtungslosen Zeitraum um die Entmagnetisierung des Stromtransformators zu gewährleisten, gibt es keine Zeit- oder Taktvorschriften für diese Betriebsart.

Die Effizienz dieser Betriebsart ist ausgezeichnet, da über dem Bypass- Schaltelement 39b nur geringe Verluste auftreten, im Vergleich zum nur kurzzeitig aktivierten Schaltelement 39 und seinem seriegeschalteten Stromtransformator 33, 34.

Der Stromtransformator 33, 34 könnte auch kleiner dimensioniert werden, und für das Bypass- Schaltelement 39b könnte man mehrere MOSFET parallel schalten.

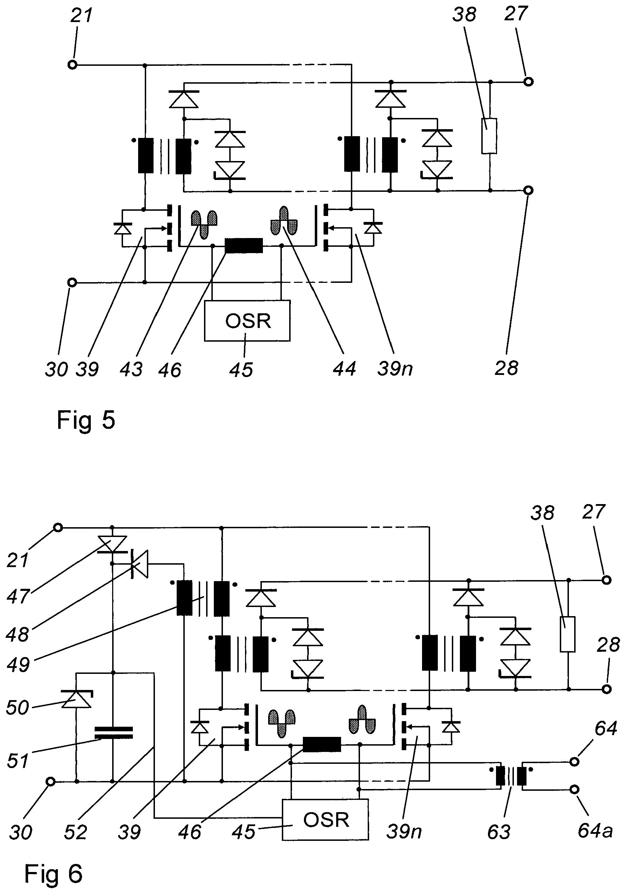

Die Fig. 5 zeigt eine weitere Ausgestaltung der Erfindung um den Energieverbrauch und die Komplexität der Sensorelektronik zu reduzieren.

Die Colpitts- Oszillatorschaltung ist ein Relikt aus dem Zeitalter der Elektronenröhren, siehe: Patentschrift US 1 624 537, Edwin H. Colpitts, angemeldet 1918.

Das Grundprinzip ist ein sogenannter LC- Schwingkreis, bestehend aus einer Induktivität und zwei Kondensatoren. Dazu braucht es noch einen Regelverstärker 45, OSR um die Amplitude und die Offsetspannung des Oszillatorsignals zu stabilisieren. Die Schaltung weist interessante Eigenschaften auf, welche für die vorliegende Erfindung genutzt werden können: die Signale über den zwei Kondensatoren sind sinusförmig und in Gegenphase. Zudem deckt der Oszillator- Regler 45, OSR nur die geringen Verluste des LC- Schwingkreises, und die Stromamplitude des Umladevorgangs ist kleiner als in LC- Schwingkreisen mit nur einem Kondensator, was zu noch kleineren Verlusten beiträgt.

Die in Fig. 5 dargestellte Schaltung ist, abgesehen von der Induktivität 46, dem Oszillator- Regler 45, OSR und den sinusförmigen Steuersignale 43, 44 identisch mit jenen der Fig. 1 und Fig. 3.

Die zwei Kondensatoren der Colpitts- Schaltung können durch die Gate- Kapazitäten des ersten Schaltelementes 39 und des zweiten Schaltelementes 39n gebildet werden. Die Colpitts- Schaltung ist prinzipiell nur für zwei Signale, d.h. nur für zwei Schaltelemente 39, 39n geeignet. Es könnten aber beispielsweise Dreiphasensysteme mit einer alternativen Signalerzeugung für Sinussignale oder Rechtecksignale durchaus Sinn machen.

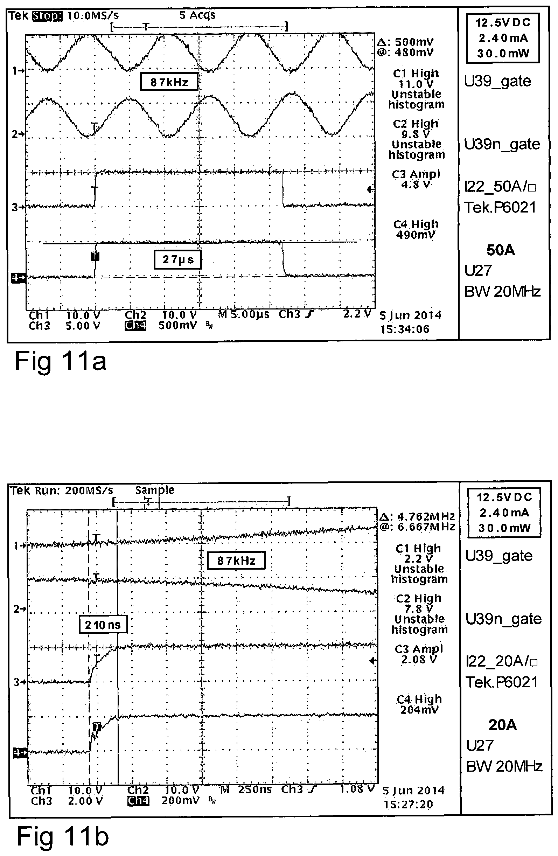

Die Fig. 11a zeigt interessante Messresultate eines Stromsensors mit einem Colpitts-Oszillator: Ch1 zeigt das 0°-Sinus- Steuersignal 43 und Ch2 das 180°-Sinus-Steuersignal 44. Die Frequenz des Colpitts- Oszillators würde bei einer Induktivität 46 von 470$\mu$H und den Gate- Kapazitäten der Schaltelemente 39, 39n von 6.1nF bei etwa 133kHz liegen. Das ist unnötig hoch und führt zu unnötigen Verlusten, offenbart aber auch das hohe Potential dieser Lösung.

Würde man nämlich die Schaltelemente 39, 39n verdoppeln, z.B. für eine Variante mit bipolaren Strömen nach Fig. 8, so würden die Kapazitäten 12.2nF und die Frequenz etwa 94kHz betragen. Bei je drei parallelen Schaltelementen 39, 39n hätte man Kapazitäten von 18.3nF und eine Frequenz von 77kHz zu erwarten. Diese Dreifach-Anordnung hätte für das vorliegende Beispiel eine maximale Stromtragfähigkeit von 300A, und hätte sogar einen etwas geringeren Energiebedarf für die Sensorelektronik als die 100A- Variante mit nur je einem Schaltelement 39, 39n.

Die Messresultate der Fig. 11a liegen mit 12.5VDC Speisespannung und 2.4mA Stromaufnahme bei einer Leistung von nur 30mW. Die Frequenz wurde mit Zusatzkondensatoren parallel zum Gate der Schaltelemente 39, 39n auf 87kHz reduziert. Vom Oszillator- Regler 45, OSR werden die Sinussignale zwischen 0V und etwa 12V stabilisiert, was bei einem Gate- Einschaltpegel von typisch 1.6V zu einem Tastverhältnis von etwa 76% und zu einem Überdeckungsgrad von etwa 52% führt.

Fig. 6 zeigt eine weitere Ausgestaltung des Beispiels von Fig. 5, welche aber genau so gut auf die anderen Beispiele der Fig. 3, Fig. 4 und Fig. 8 angewendet werden kann. Um dem Idealbild des Gleichstromtransformators noch näher zu kommen, wird ein primärseitiger Energie- Ernter 47-51 vorgeschlagen. Das erübrigt eine Energieversorgung der Sensorelektronik aus anderen Quellen, wie aus vorhandenen Treiberschaltungen der Leistungselektronik, oder über DC/DC- Konverter aus der übergeordneten Steuerelektronik.

Vor Beginn eines Stromflusses in den Laststromeingang 21 ist der Oszillator- Regler 45, OSR ohne Speisespannung und die Schaltelemente 39, 39n sind entsprechend im nicht leitenden Zustand. Sobald ein Strom in den Laststromeingang 21 fließt, wird die Speicherkapazität 51 über die Diode für Spannungsspeisung 47 in sehr kurzer Zeit aufgeladen, der Oszillator- Regler 45 wird über die Leitung 52 mit Spannung versorgt und die Schaltelemente 39, 39n werden abwechslungsweise leitend geschaltet. Die Diode für Spannungsspeisung 47 liegt danach in Sperrrichtung, und wird entsprechend wirkungslos.

Hier muss angefügt werden, dass für Anwendungen wo sehr lange stromlose Pausen zwischen Impulsen vorliegen können, die Anordnung der Diode für Spannungsspeisung 47 nicht ideal ist. Wird nämlich die Spannungsversorgung mit jedem Strom- Impuls neu über die Diode für Spannungsspeisung 47 hochgefahren, so fehlt dieser Anteil des Laststromes im Messresultat am Messanschluss 27.

Für diese Fälle ist es angebracht die Diode für Spannungsspeisung 47 durch zwei oder n Dioden zu ersetzen und deren Anoden an die Drain- Anschlüsse der Schaltelemente 39 bis 39n zu verbinden. Durch diese Maßnahme wird auch der Ladestromimpuls für die Speicherkapazität 51 über die Stromtransformatoren 33, 34 bis 33n, 34n geleitet, und entsprechend ebenfalls gemessen.

Nach dem Ladestromimpuls für die Speicherkapazität 51, übernimmt sofort der Stromerntetransformator 49 die Versorgung der Sensorelektronik über die Diode für Stromspeisung 48. Der Stromerntetransformator 49 kann gleich oder ähnlich den Stromtransformatoren 33, 34 und 33n, 34n ausgelegt sein, und nur in den ersten Stromzweig 33, 39, oder auch in den restlichen Stromzweigen 33n, 39n eingefügt sein.

Der Stromerntetransformator 49 verursacht überhaupt keinen Messfehler, da er zum Stromtransformator 33, 34 in Serie geschaltet ist. Auf der Primärseite des Stromsensors würde man aber, je nach Stromfluss einen um wenige 10mV höheren Spannungsabfall feststellen.

Die Spannungsreglerdiode 50 kann eine einfache Zenerdiode sein. Man wird aber um unnötige Verluste zu vermeiden, im Überspannungsfall vorteilhafterweise über ein (nicht gezeichnetes) Schaltelement die Sekundärwicklung des Stromwandlers 49 kurzschließen, womit ein übermäßiger Energiefluss verlustarm unterbunden wird.

Für eine Anwendung nach Fig. 8, mit bipolaren Strömen kann die Strom- ErnteSchaltung 49, 48, 51 alternativ für Spannungsverdopplung ausgelegt werden. Die Diode für Stromspeisung 48 wird doppelt, d.h. für beide Stromrichtungen ausgelegt und die Speicherkapazität 51 wird ebenfalls doppelt in Serieschaltung ausgeführt.

Die Energieversorgung der Sensorelektronik aus dem Primärkreis führt auch zu einer Erhöhung der passiven Sicherheit, weil hier Stromfluss und Spannungsversorgung der Sensorelektronik direkt gekoppelt sind.

Als Weitergestaltung der Colpitts- Lösung kann parallel zur Induktivität 46 ein Signaltransformator 63 angeschlossen werden. Der Signalanschluss 64 liefert das sekundäre 0°-Sinus- Steuersignal 58 der Fig. 8, und der Signalanschluss 64a liefert das sekundäre 180°-Sinus- Steuersignal 59. Da das Transformatorprinzip vorwärts und rückwärts gleich gut funktioniert, kann die Energieversorgung von der Primärseite her, oder von der Sekundärseite her, oder sogar redundant von beiden Seiten erfolgen.

Die Fig. 7 geht anhand des Beispiels nach Fig. 4 nochmals auf das Problem der Signalkonditionierung und der Bereichserweiterung ein. Die nachfolgenden Ausführungen sind auch hier für die anderen Beispiele nach Fig. 3, 5, 6 und 8 zutreffend.

Die Konditionierungs- Schaltung 56, S&H, RCP, FLT kann die Sample & Hold-Schaltung 41, S&H, eine Ripple-Kompensations- Schaltung RCP, und / oder einen Filter, FLT zur Limitierung der oberen Grenzfrequenz enthalten.

Eine Ripple- Kompensations- Schaltung 56, RCP kann beispielsweise die Anodenspannung der Diode in Stromrichtung 35 als Eingangssignal für einen Integrator verwenden, um daraus eine Rampe zu bilden, welche die Temperatur- und Strombelastung des Sensors schon berücksichtigt. Als einzige nicht berücksichtigte Störquelle bliebe der sekundäre Kupferwiderstand des Stromtransformators 33, 34. Es ist aber anzunehmen, dass der Einfluss des Kupferwiderstandes eigentlich immer gleich verläuft, wie jener der Strombelastung und der Temperatur, und dieser kann somit proportional mitberücksichtigt werden.

Die Filterfunktion 56, FLT enthält meist einen T- oder $\pi$- Tiefpass, eventuell kombiniert mit einem Hochfrequenz-Gleichtaktfilter. Diese Maßnahmen sind wichtig, wenn beispielsweise das Messsignal digital abgetastet werden soll, oder wenn Gleichtaktstörungen vorliegen.

Weiter ist ein Synchronisations- Ausgang 62 vorgesehen, welcher anstelle der Sample & Hold- Schaltung 41, S&H, die übergeordnete Steuerelektronik anweisen kann, auf Signale während dem beobachtungslosen Zeitraum nicht zu reagieren.

Zusätzlich kann ein Bereichswahl- Eingang 55 zur Messbereichs- Erweiterung beitragen. Das Bereichs- Schaltelement 54, bevorzugt ein MOSFET, kann den parallelen Messwiderstand 53 zum Messwiderstand 38 parallel schalten, und würde für das Beispiel nach Fig. 8 entsprechend bidirektional vorgesehen. Als Beispiel einer Bereichserweiterung auf vier Dekaden sei der Messwiderstand 38 mit 100Ω angenommen, der parallele Messwiderstand 53 mit 1Ω und das Bereichs-Schaltelement 54 mit einem Einschaltwiderstand von 10mΩ angenommen. Die Parallelschaltung dieser Konfiguration würde 999.999mΩ betragen und würde infolge einer typischen Abweichung des Einschaltwiderstandes des Bereichs-Schaltelementes 54 auf maximal 14mΩ, höchstens 1.004Ω betragen. Das ist eine maximale thermisch- und streuungsbedingte Abweichung von 5‰, welche für die meisten Anwendungen toleriert werden kann.

Bei einem Übersetzungsverhältnis der Stromtransformatoren 33, 34 und 33n, 34n von 1:100 ergeben sich folgende Spannungen zwischen den Messanschlüssen 27, 28: bei 10mA und 100Ω = 10mV; bei 1A und 100Ω = 1V; bei 1A und 1Ω = 10mV; bei 100A und 1Ω = 1V.

Der Messbereich erstreckt sich von 10mA bis 100A also tatsächlich über vier Dekaden und kann durch das Übersetzungsverhältnis der Stromtransformatoren 33, 34 und 33n, 34n fast beliebig gegen tiefere oder höhere Ströme verschoben werden. Das sind ideale Eigenschaften für Anwendungen in digitalen Multimetern oder in Energiezählern.

Die vorgehend diskutierten Dimensionierungs- Regeln zur Wahl der Frequenz, Tastverhältnis und Spannungswahl für die Entmagnetisierung müssen auch hier sorgfältig befolgt, oder sogar flexibel gestaltet werden.

Die Fig. 8 zeigt die notwendigen Modifikationen gegenüber der Fig. 3 um bipolare Ströme zu messen. Diese einfachen Maßnahmen um den Stromsensor für bidirektionale Ströme auszulegen, können ebenfalls für die anderen Beispiele angewendet werden.

Als erster Schritt müssen die primären Schaltelemente 60, 60n für Wechselstrom ausgelegt werden. Das erfolgt am einfachsten durch eine Verdoppelung der primären Schaltelemente 60, 60n, d.h. Anti- Serieschaltung von bevorzugt zwei MOSFET. Die beiden Source- Anschlüsse sowie die beiden Gate- Anschlüsse werden dabei je direkt verbunden.

Für kleinere primärseitige Teilströme 23, 24 würde nur ein MOSFET 39, 39n, wie für die monopolaren Ströme dargestellt, eigentlich völlig genügen, denn ein MOSFET leitet in beide Richtungen gleich gut. Ein Problem entsteht aber wegen der parasitären Diode 40, welche bei höheren Strömen während der Entmagnetisierungsphase für negative Ströme teils leitend bleibt, und dadurch die Stromtransformatoren 33, 34 und 33n, 34n in die Sättigung treiben kann.

Bei der vorgeschlagenen Lösung nach Fig. 8 liegen die parasitären Dioden 40 in AntiSerie und können deshalb die Entmagnetisierung nicht behindern.

Das erste Steuersignal 31 und das letzte Steuersignal 32 müssten normalerweise über die Source- Anschlüsse (und nicht wie gezeichnet, über den unteren Drain- Anschluss) verbunden werden. Nur, die anliegenden Spannungen zwischen Source- Anschluss und Drain- Anschluss sind derart gering, dass man auf diese aufwändigere Verbindungen meistens verzichten kann.

Falls das Potential des Laststromausgangs 30 auf dem gleichen Potential wie der Nullreferenz- Messanschluss 28 liegen würde, könnte sogar das erste Steuersignal 31 direkt auch das sekundäre 0°-Steuersignal 58, und das letzte Steuersignal 32 direkt auch das sekundären 180°-Steuersignal 59 bilden. Das wäre typisch für den Fall, wo die Sensorelektronik aus einer Treiberschaltung der Leistungselektronik mit Energie versorgt wird, und ein Regelkreis lokal geschlossen wird, wie das schon anhand der Fig. 2 zum Stand der Technik erläutert wurde. Das wäre auch typisch für eine Anwendung in einem Digitalmultimeter (DMM), wo keine Potentialtrennung erforderlich ist, weil das gesamte Gehäuse schutzisoliert ist.

Als zweiter Schritt müssen die sekundären Dioden in Stromrichtung 35, 35n durch bidirektionale Schaltelemente 61, 61n ersetzt werden. Die bidirektionalen Schaltelemente 61, 61n müssen synchron mit den entsprechenden primären Schaltelemente 60, 60n geschaltet werden um ein genaues Abbild des Wechselstromes über dem Messwiderstand 38 und am Messanschluss 27 zu garantieren.

Zusätzliche isolierte Signalübertragungen zwischen Primär- und Sekundärseite werden damit für eine potentialfreie Strommessung unumgänglich. Eigentlich wäre jeglicher zusätzliche Pfad zwischen Primär- und Sekundärseite absolut unerwünscht, seien es nun Spannungsversorgungen oder Signale. Es gibt aber aktuell ein großes Angebot von isolierten Signal- Kopplern, nach den verschiedensten Übertragungsprinzipien wie: transformatorisch, magnetoresistiv, optisch oder kapazitiv, mit Bandbreiten bis über 50MHz und kleinsten Koppelkapazitäten um 1 bis 3pF, so dass hier kein echtes Problem vorliegt.

Als dritter und letzter Schritt muss noch die sekundäre Entmagnetisierung 36, 37 auf bidirektionalen Betrieb umgestellt werden. Die einfachste Lösung ist, die Diode in Sperrrichtung 36 durch eine Zenerdiode 57 in Antiserie zur Zenerdiode 37 zu ersetzen. Eine elegantere und ökologischere Lösung wäre, die magnetische Energie über zwei Dioden für die zwei Stromrichtungen in eine positive und eine negative Spannungsquelle (falls vorhanden) der Steuerelektronik zu rekuperieren. Für höhere Magnetisierungsströme und / oder hoher Frequenz kann das durchaus ökologisch und lohnend sein.

Die Ausführungsform nach Fig. 8 ist ideal geeignet, beispielsweise im Inverter nach Fig. 5 der erwähnten Patentschrift US 5 815 391, den Motorphasenstrom direkt im, mit (MOTOR CURRENT) bezeichneten Leiter zu messen.

Das ist der einzige Ort eines Inverterzweiges, wo der tatsächliche Phasenstrom über die verlangte große Bandbreite gemessen werden kann. Alle anderen Verfahren sind indirekte Messungen, oder sogar nur Berechnungen, und führen zwangsläufig zu den vorgehend diskutierten Störungen und Nachteilen.

Die Energieversorgung der primärseitigen Sensorelektronik könnte dabei beispielsweise aus der Treiberschaltung (PWM Signal upper IGBT) des oberen Schaltelementes 50 erfolgen.

Für die Messungen betreffend Fig. 9a bis Fig. 12, der verschiedenen Ausführungsformen, wurde folgende Messausrüstung der Firma Tektronix, USA: www.tek.com verwendet: Oszilloskop TDS 640A, Spannungssonden 10:1 P6139A, Wechselstromsonde P6021 und digitale Multimeter DMM254.

Die Wechselstromsonde P6021, seit 1969 auf dem Markt, hat sich für Messungen im Frequenzbereich zwischen 120 Hz und 60MHz als de facto Standard etabliert. Die Stromsonde hat bei 10mA/mV und 2.75m Kabellänge eine Verzögerungszeit von weniger als 16ns und eine Anstiegszeit von weniger als 4ns.

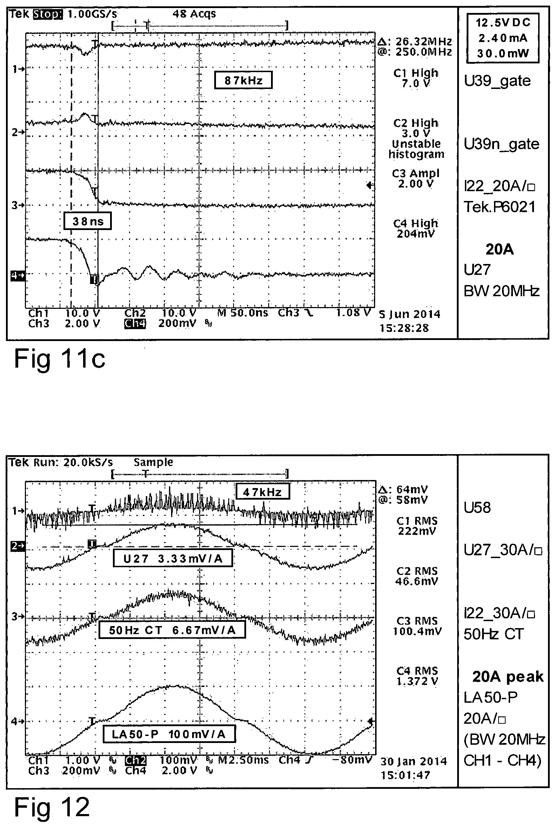

Für die 50 Hz Wechselstrom- Messung in Fig. 12 wurde der vorerwähnte Stromwandler IE 0,5/200 der Firma REO verwendet, und mit einem DC bis 200kHz Kompensations- Stromwandler LA50-P der Firma LEM, CH: www.lem.com verglichen.

Die Fig. 9a bis 10b zeigen die Einflüsse vom primärseitigen Gesamtstrom 22, und der Frequenz der Steuersignale 31, 32 auf das Messresultat zwischen den Messanschlüssen 27, 28.

Der Messaufbau entspricht Fig. 3, mit einem Treiberbaustein IR21531S einstellbarer Frequenz für die Steuersignale 31, 32 und einer asymmetrischen Ansteuerung der

MOSFET- Schaltelemente 39, 39n vom Typ IRFH4201, um mit einfachsten Mitteln überlappenden Betrieb zu ermöglichen.

Die Stromtransformatoren 33, 34 und 33n, 34n sind, wie erwähnt vom Typ PB0026, die Zenerdioden 37, 37n haben eine Nenn- Durchbruchspannung von 13V und der Messwiderstand 38 hat einen Widerstand von 1Ω.

Ein Testgenerator mit 660μF Speicherkapazität, variabler 0 bis 300VDC Spannungsquelle und 1.875 Ω Ausgangswiderstand ermöglicht theoretisch Impulse von 0 bis 160A.

Fig. 9a zeigt den Fall eines geringen Laststromes 22 von 1A bei 560μs Dauer bei einer zu tief gewählten Frequenz der Steuersignale 31, 32 von 10kHz.

Es zeigen:

Ch1: die Spannung auf der Zenerdiode 37, welche sich infolge deren Kapazität während dem Impuls nur langsam bis -13V aufbaut. In der Impulspause wird die Spannung durch den Widerstand von 10MΩ der Spannungssonde P6139A entladen.

Ch2: das Steuersignal 31, gemessen am Gate des Schaltelementes 39. Man erkennt die asymmetrische schnelle Ladung und langsame Entladung der Gate- Kapazität.

Ch3: den primären Gesamtstrom 22, gemessen mit der Stromsonde P6021. Hier manifestiert sich bereits die untere Frequenzlimite der P6021 durch den Abfall der Amplitude über die Pulsdauer und negativer Unterschwingung nach dem Impulsende.

Ch4: die auf 20MHz Bandbreite limitierte Spannung am Messanschluss 27 mit charakteristischen dreieckigen Zacken, welche durch den im Stromtransformator 33, 34 abgezweigten, und hier fehlenden, Magnetisierungsstrom verursacht werden. Die negative Offsetspannung von etwa 20mV ist in diesem Fall ein Messproblem auf Ch4, und nicht wirklich vorhanden.

Fig. 9b zeigt den Fall eines großen Laststromes 22 von 100A bei 560μs Dauer, bei einer Frequenz der Steuersignale 31, 32 von 10kHz.

Es zeigen:

Ch1: die Spannung auf der Zenerdiode 37, welche sich während dem Impuls infolge des höheren Magnetisierungsstromes schneller bis etwa -15V aufbaut.

Ch2: das Steuersignal 31, gemessen am Gate des Schaltelementes 39.

Ch3: den primären Gesamtstrom 22, gemessen mit der Stromsonde P6021. Hier manifestiert sich die Strom- Zeitlimite. Die Stromsonde P6021 geht nach etwa 30μs in Sättigung.

Ch4: die auf 20MHz Bandbreite limitierte Spannung am Messanschluss 27 mit leicht abfallender Amplitude. Dieser Abfall wird aber durch die Zeitkonstante von 1.24ms des Testgenerators verursacht. Eine Welligkeit infolge abgezweigtem Magnetisierungsstrom ist nicht mehr erkennbar.

Fig. 10a zeigt den gleichen Fall eines geringen Laststromes 22 von 1A bei 560μs Dauer, aber einer gut gewählten Frequenz der Steuersignale 31, 32 von 20kHz.

Es zeigen:

Ch1: die Spannung auf der Zenerdiode 37, welche sich infolge der geringeren Magnetisierung kaum noch aufbaut.
Ch2: das Steuersignal 31, gemessen am Gate des Schaltelementes 39.
Ch3: den primären Gesamtstrom 22, gemessen mit der Stromsonde P6021. Hier manifestiert sich die untere Frequenzlimite der P6021 wie in Fig. 9a.

Ch4: die auf 20MHz Bandbreite limitierte Spannung am Messanschluss 27 mit brauchbarer Qualität, angesichts der geringen Amplitude von nur 10mV. Die Welligkeit infolge des abgezweigten Magnetisierungsstromes ist kaum noch vorhanden. Das in Fig. 9a aufgetretene Offsetproblem wurde behoben, und ist hier nicht mehr sichtbar.

Fig. 10b zeigt den Fall eines großen Laststromes 22 von 100A bei 560µs Dauer, bei einer Frequenz der Steuersignale 31, 32 von 20kHz.

Es zeigen:

Ch1: die Spannung auf der Zenerdiode 37, welche sich infolge der etwas höheren Magnetisierung schneller bis etwa -14V aufbaut.
Ch2: das Steuersignal 31, gemessen am Gate des Schaltelementes 39.
Ch3: den primären Gesamtstrom 22, gemessen mit der Stromsonde P6021. Auch hier manifestiert sich die Strom-Zeitlimite. Die Stromsonde P6021 geht nach etwa 30µs in Sättigung.
Ch4: das auf 20MHz Bandbreite limitierte Signal am Messanschluss 27 mit leicht abfallender Amplitude. Der Abfall wird auch hier durch die Zeitkonstante von 1.24ms des Testgenerators verursacht.

In den Kästchen oben rechts der Fig. 9a bis Fig. 10b ist jeweils die Speisespannung, der aufgenommene Strom und die daraus resultierende Leistung der Sensorelektronik angegeben. Dabei fällt auf, dass der primäre Gesamtstrom 22 keinen Einfluss auf den Energieverbrauch der Sensorelektronik hat.

Das ist bemerkenswert, denn die meisten bekannten Strommessverfahren wie Rogowski Coil, Closed- Loop-Hall- Effekt, Flux- Gate, oder besonders gravierend, das Verfahren nach der vorgehend diskutierten Patentschrift US 5 196 784 basieren auf Kompensationsströmen, welche einen zum Messstrom mindestens proportionalen Speisestrom für die Sensorelektronik verlangen. Das vorteilhafte Verhalten der Erfindung, ist ein wichtiger Beitrag zur Erfüllung der Forderung nach einer geringen Speiseleistung für die Sensorelektronik.

Hingegen steigt der Energieverbrauch proportional mit der Frequenz der Steuersignale 31, 32 und auch, hier zwar nicht ersichtlich, proportional mit der Speisespannung der Sensorelektronik.

Fig. 11a bis Fig. 11c zeigen Messresultate eines Aufbaus mit dem Colpitts- Oszillator nach Fig. 5, welcher mit dem vorgehend verwendeten Testgenerator (660µF, 1.875Ω), hier jedoch bei 27µs Impulszeit untersucht wurde. Für den Aufbau wurden gleiche Bauteile verwendet, wie für die vorgehenden Messungen der Fig. 9a bis Fig. 10b.

Es zeigen:

Ch1: das 0°-Sinus Steuersignal 43, gemessen am Gate des Schaltelementes 39.
Ch2: das 180°-Sinus Steuersignal 44, gemessen am Gate des Schaltelementes 39n.
Ch3: den primären Gesamtstrom 22, gemessen mit der Stromsonde P6021. Bei 27µs Impulszeit misst die P6021 Ströme bis gegen 100A zuverlässig.
Ch4: das auf 20MHz Bandbreite limitierte Signal am Messanschluss 27.

In Fig. 11a stellt man fest, dass die Ausgangsspannung am Messanschluss 27 völlig frei von Einflüssen der sinusförmigen Steuersignale 43, 44 ist, und dass der rechteckige Strom von 50A Amplitude perfekt abgebildet ist.

Das bestätigt sich in der vergrößerten Abbildung der Fig. 11b für die Anstiegszeit. Die Anstiegszeit von 210 ns ist auch hier durch den Testgenerator verursacht, welcher eine nicht zu vernachlässigende Induktivität aufweist, und für 20A bei weniger als 40VDC Speisespannung betrieben wird. Das Messsignal am Messanschluss 27 stimmt sehr gut mit dem Messsignal der Stromsonde P6021 überein.

Interessant ist auch die Tatsache, dass die Sensorelektronik mit Colpitts- Oszillator bei einer Frequenz von 87kHz und 30mW, weniger Leistung aufnimmt als die Lösung der Fig. 3 bei 10kHz und 35mW. Extrapoliert aus Fig. 9a und Fig. 10a, würde dieser Stromsensor nach Fig. 3 bei 87kHz eine Leistung von über 240mW benötigen. Das ist das achtfache der Colpitts- Lösung nach Fig. 5 und eine überzeugende Bestätigung der theoretischen Überlegungen.

In der vergrößerten Abbildung der Fig. 11c ist ebenfalls der Testgenerator für die Abfallzeit von 38ns verantwortlich. Die Abfallzeit ist viel kürzer als die Anstiegszeit, weil hier die Spannung einer 300V- Schutzdiode wirksam ist.

Das Messsignal am Messanschluss 27 scheint mindestens gleich schnell zu sein wie die Stromsonde P6021, dabei ist der Ch4 in der Bandbreite auf 20MHz limitiert. Es wäre sogar durchaus möglich, dass die Schwingungen nach dem Abfall des Stromes tatsächlichen Stromschwingungen im Primärstromkreis entsprechen würden.

Fig. 12 zeigt die Messresultate eines Aufbaus für bipolare Ströme nach Fig. 8, welcher mit einem 50Hz Wechselstrom- Testgenerator belastet wurde. Für den Aufbau wurden ähnliche Bauteile verwendet, wie für die vorgehenden Messungen.

Die primären Schaltelemente 60, 60n sind aber MOSFET IRFS3004-7, die sekundären Schaltelemente 61, 61n sind MOSFET IRFL110, alle von der Firma International Rectifier.

Der Messwiderstand 38 beträgt 333mΩ und besteht aus drei parallelen 1Ω SMD-Widerständen.

Alle Messkanäle (Ch1-Ch4) wurden in der Bandbreite auf 20MHz limitiert.

Es zeigen:

Ch1: das rechteckförmige sekundäre 0°-Steuersignal 58, gemessen am Gate des sekundären bipolaren Schaltelementes 61. Das Steuersignal 31 weist eine Frequenz von 47kHz auf, ist jedoch mit 20kS/s unter- abgetastet und deshalb nicht richtig abgebildet.

Ch2: die Spannung mit 3.33mV/A am Messanschluss 27, bei einer Stromamplitude von 20A und 50Hz.

Ch3: den primären Gesamtstrom 22, gemessen mit einem Stromwandler IE 0,5/200 der Firma REO, mit einer Ausgangsspannung von 6.67mV/A.

Ch4: den primären Gesamtstrom 22, gemessen mit einem Kompensations-Stromwandler LA50-P der Firma LEM, mit einer Ausgangsspannung von 100mV/A.

Das schlechteste Ergebnis liefert der 50Hz- Stromwandler auf Ch3, welcher eine höhere Störspannung aufweist als der Messanschluss 27, dies obschon Ch3 um Faktor zwei weniger verstärkt ist als Ch2. Für 50Hz- Messungen ist das kein Problem, möchte man aber beispielsweise Oberwellen im Strom nachweisen, kann nicht einfach beliebig tiefer gefiltert werden.

Rein optisch scheint der Kompensations- Stromwandler auf Ch4 am besten abzuschneiden. Das täuscht aber insofern, als dass das Signal des Kompensations-Stromwandlers 20 mal weniger verstärkt ist, als jenes des Messanschlusses 27. Der Unterschied ist also nicht wirklich vorhanden, sondern nur durch die Messanordnung verursacht.

Alle drei Messprinzipien decken sehr schön einen Sinusfehler im Nulldurchgang auf. Wie erst nachträglich festgestellt wurde, hat der 50Hz Testgenerator eine sogenannte Softstartschaltung eingebaut. Diese Schaltung mit einem Triac- Schaltelement, ist für den Nulldurchgangs- Fehler verantwortlich.

Gleichzeitig niederfrequente und hochfrequente Phänomene zu erfassen, ermöglicht nur der erfindungsgemässe Stromsensor. Dessen große Bandbreite erlaubt beispielsweise tiefste Schaltfrequenzen in leistungselektronischen Schaltungen um eine hohe Effizienz zu erreichen, ermöglicht aber dennoch auf stochastische Störfälle wie Kollisionen oder Kurzschlüsse augenblicklich reagieren zu können. Ähnliche Vorteile ergeben sich für Anwendungen in hochdynamischen Antrieben, wo die extrem kurzzeitigen Beschleunigungen oder Verzögerungen nun viel genauer unter Kontrolle sind, als beispielsweise mit Stromwandlern nach dem Hall- Effekt- Prinzip.

Als weiteres Beispiel können die Gleichstromkomponente eines Wechselstromes, dessen Oberwellen und leitergebundene Störungen gleichzeitig gemessen werden. Eingebaut in digitale Multimeter oder in Energiezählern, könnten die Strommess-Funktionen also, um beispielsweise Spitzenwerte, Effektivwert, harmonische Komponenten, DC- AC- und HF Anteile und andere statistische Werte erweitert werden. Zusätzlich könnte der Strom- Messbereich ohne eine mechanische Umschaltung stark ausgedehnt werden.

Fasst man die Resultate der aufgeführten, nicht einschränkend zu verstehenden Beispiele zusammen, so stellt man fest, dass die erfindungsgemässen Lösungen für alle Messaufgaben mindestens gleich gute, oder bedeutend bessere Resultate liefern als alle bisher bekannten Messverfahren. Der in der Problemstellung gewünschte ideale Gleichstromtransformator hoher Bandbreite, wird mit der Erfindung nahezu Realität.

Damit kann gesagt werden, dass Stromsensoren nach den vorliegenden Verfahren und Vorrichtungen universeller einsetzbar und zudem kleiner, leichter und preiswerter sind als andere Strom- Messprinzipien.

Es liegt im Belieben des Fachmannes, beispielsweise Kombinationen aus den offenbarten Lösungen auszuwählen, Parallelschaltungen von Schaltelementen, Stromtransformatoren oder deren Gruppen zur Erhöhung der Stromtragfähigkeit vorzusehen, oder ähnliche Modifikationen vorzunehmen. Alle Verfahren und Vorrichtungen welche dem Sinn und Zweck der vorliegenden Erfindung entsprechen, sollen wie nachfolgend in den Ansprüchen definiert, geschützt werden.

**Bezugszeichen:**

1    Isolierplatte (Prior Art)

2    Zuleitungselektrode (Prior Art)

3    Zuleitungselektrode (Prior Art)

4    Widerstandsstreifen (Prior Art)

5    Widerstandsstreifen (Prior Art)

6    Stromanschluss (Prior Art)

7    Stromanschluss (Prior Art)

8    Erste Kontaktierung (Prior Art)

9    Zweite Kontaktierung (Prior Art)

10   Kontaktierung (Prior Art)
11   Kontaktierung (Prior Art)
12   (Prior Art)
13   Anschluss (Prior Art)
14   Anschluss (Prior Art)
15   (Prior Art)
16   (Prior Art)
17   (Prior Art)
18   (Prior Art)
19   (Prior Art)
20   Differenzverstärker (Prior Art)
21   Laststromeingang
22   Primärseitiger Gesamtstrom
23   Erster primärseitiger Teilstrom
24   Zweiter primärseitiger Teilstrom
25   Erster sekundärseitiger Teilstrom
26   Zweiter sekundärseitiger Teilstrom
27   Messanschluss
28   Nullreferenz Messanschluss
29   Sekundärseitiger Gesamtstrom
30   Laststromausgang
31   Erstes Steuersignal
32   Letztes Steuersignal
33   33n Erste, letzte Primärwicklung, Stromtransformator
34   34n Erste, letzte Sekundärwicklung, Stromtransformator
35   35n Erste, letzte sekundäre Diode in Stromrichtung
36   Diode in Sperrrichtung
37   37n Spannungs- begrenzendes Element
38   Messwiderstand
39   39n Erstes, letztes Schaltelement, 39b Bypass- Schaltelement
40   Parasitäre Diode
41   Sample & Hold Schaltung, S&H
42   Freigabesignal
43   0°-Sinus Steuersignal
44   180°-Sinus Steuersignal
45   Oszillator Regler, OSR
46   Induktivität
47   Diode für Spannungsspeisung
48   Diode für Stromspeisung
49   Stromerntetransformator
50   Spannungsreglerdiode
51   Speicherkapazität
52   Leitung
53   Paralleler Messwiderstand
54   Bereichswahl-Schaltelement
55   Bereichs- Eingang
56   Konditionierungs- Schaltung, S&H, RCP (Ripple- Komp.), FLT (Filter)
57   57n Zenerdiode in Antiserie
58   Sekundäres 0°-Steuersignal
59   Sekundäres 180°-Steuersignal
60   60n Primäres bidirektionales Schaltelement
61   61n Sekundäres bidirektionales Schaltelement
62   Freigabe- Signalausgang
63   Signaltransformator
64   64a Signalanschlüsse
65   Auslöseschaltung TRG
66   Triggeranschluss
67   Auslösesignal

68    Erstes Steuerimpuls- Signal
69    Zweites Steuerimpuls- Signal

**Begriffe:**

- Beobachtungszeitdauer (Messzeit)

- Beobachtungspause (Pausenzeit)

- Stromtragfähigkeit (Strombelastbarkeit nach Datenblatt)

- SMD (Surface Mounted Device, unbedrahtetes Bauelement)

- MOSFET (Metal Oxide Semiconductor Field Effekt Transistor, Metall-Oxid gesteuerter Feldeffekttransistor)

- JFET (Junction-gate Field Effect Transistor, Trennschicht- gesteuerter Feldeffekttransistor)

- DMM (Digital Multi Meter, digitales Universalmessgerät)

**Patentansprüche**

1.  Verfahren für eine potentialfreie Strommessung in leistungselektronischen Schaltungen und an elektrischen Einrichtungen, **dadurch gekennzeichnet, dass** ein zu messender Strom (22) unterbruchsfrei und zeitweise aufgeteilt über mehrere parallele Pfade der Strommessung (33, 39) (33n, 39n) (39b) (33, 60) (33n, 60n) geführt wird, und dass die Pfade aus einer Serieschaltung von Schaltelementen (39, 39n, 60, 60n) mit Primärwicklungen (33, 33n) von Stromtransformatoren (33, 34, 33n, 34n), oder von einem Bypass- Schaltelement (39b) gebildet sind, und dass in Sekundärwicklungen (34, 34n) induzierte sekundärseitige Teilströme (25, 26) einem Übersetzungsverhältnis der Stromtransformatoren (33, 34, 33n, 34n) entsprechend, zu einem sekundärseitigen Gesamtstrom (29) summiert und abgebildet und über einen Messanschluss (27) ausgewertet werden, und dass während Unterbruchszeiten der Schaltelemente (39, 39n, 60, 60n) eine gespeicherte magnetische Energie, der Stromtransformatoren (33, 34, 33n, 34n) in Spannungs- begrenzende Elemente (37, 37n, 57, 57n) abgeführt wird.

2.  Verfahren nach Anspruch 1 **dadurch gekennzeichnet, dass** der zu messende Strom (22) über die Primärwicklungen (33, 33n) der mindestens zwei Stromtransformatoren (33, 34, 33n, 34n) aufgeteilt wird, und über mindestens zwei seriegeschaltete primäre Schaltelemente (39, 39n) zeitweise überlappend geführt wird, und dass die sekundärseitigen Teilströme (25, 26) über Dioden (35, 35n) in Stromrichtung auf einen Messwiderstand (38) geleitet und summiert werden, und dass die gespeicherte magnetische Energie der Stromtransformatoren (33, 34, 33n, 34n) während der Unterbruchszeit über Dioden (36, 36n) in Sperrrichtung der sekundärseitigen Teilströme (25, 26) in die Spannungs- begrenzenden Elemente (37, 37n, 57, 57n) abgeführt wird.

3.  Verfahren nach Anspruch 2 **dadurch gekennzeichnet, dass** die seriegeschalteten Schaltelemente (39, 39n) mit einer weichen Schalt- Charakteristik, bevorzugt mit einer Resonanz- Charakteristik geschaltet werden.

4.  Verfahren nach Anspruch 3 **dadurch gekennzeichnet, dass** die seriegeschalteten Schaltelemente (39, 39n) mit individuell phasenversetzten Sinussignalen (43, 44) angesteuert werden, wobei die Amplitude der Sinussignale einen solchen Minimalwert, und einen solchen Maximalwert aufweisen, dass die seriegeschalteten Schaltelemente (39, 39n) mit einer bestimmten Überlappung in den leitenden Zustand versetzt werden.

5.  Verfahren nach Anspruch 2 **dadurch gekennzeichnet, dass** der zu messende Strom (22) bidirektional ist, und seriegeschaltete primäre bidirektionale Schaltelemente (60, 60n) bidirektional Strom führen können, und dass anstelle der Dioden (35, 35n) in Stromrichtung sekundäre bidirektionale Schaltelemente (61, 61n) die sekundären Teilströme (25, 26) auf den Messwiderstand (38) führen, und dass die sekundären bidirektionalen Schaltelemente (61, 61n) synchron mit den entsprechenden seriegeschalteten primären bidirektionalen Schaltelementen (60, 60n) geschaltet werden, und dass die Spannungs- begrenzenden Elemente (37, 37n, 57, 57n) für die Entladung der Magnetkreise bidirektional wirken.

6. Verfahren nach Anspruch 2 **dadurch gekennzeichnet, dass** der zu messende Strom (22) monodirektional ist, und die seriegeschalteten Schaltelemente (39, 39n) nur für eine Stromrichtung vorgesehen sind.

7. Verfahren nach Anspruch 2 **dadurch gekennzeichnet, dass** eine Kompensationsschaltung (56, RCP) ein rampenförmiges Signal so synchron zwischen den Unterbruchszeiten erzeugt und zu einem Signal am Messanschluss (27) addiert, dass ein von einem Magnetisierungsstrom verursachter Fehler gerade kompensiert wird.

8. Verfahren nach Anspruch 2 **dadurch gekennzeichnet, dass** zum Messwiderstand (38) mindestens ein zusätzlicher Messwiderstand (53) über mindestens ein Bereichswahl- Schaltelement (54) für eine Mess- Bereichserweiterung zugeschaltet werden kann.

9. Verfahren nach Anspruch 1 **dadurch gekennzeichnet, dass** der zu messende Strom (22) während einer bestimmten Beobachtungszeitdauer über die Primärwicklung (33) des ersten Stromtransformators (33, 34) und des ersten seriegeschalteten Schaltelementes (39) geführt wird, und dass während einer Beobachtungspause der zu messende Strom (22) direkt und ohne Messung über das Bypass- Schaltelement (39b) geführt wird, und dass die Messung nur während der Beobachtungszeitdauer ausgewertet wird, oder der letzte Messwert der Beobachtungszeitdauer während der Beobachtungspause beibehalten wird.

10. Verfahren nach Anspruch 9 **dadurch gekennzeichnet, dass** die Beobachtungszeitdauer durch ein übergeordnetes System ausgelöst wird, und dass statistische Werte des zu messenden Stromes (22) aus mehreren Beobachtungszeitdauern gebildet werden, oder der zu messende Strom (22) während der Beobachtungszeitdauer von dem übergeordneten System mehrfach abgetastet wird um die statistischen Werte zu bilden.

11. Vorrichtung für eine potentialfreie Messung von Gleich- oder Wechselstrom (22) bestehend aus Stromtransformatoren (33, 34, 33n, 34n) und monodirektionale oder bidirektionale Schaltelementen (39, 39n, 39b, 60, 60n, 61, 61n) und elektronischen Steuermitteln (41, 45, 65) und Dioden (35, 35n) und Spannungsbegrenzenden Elementen (36, 36n, 37, 37n, 57, 57n) und einem Messwiderstand (38), **dadurch gekennzeichnet, dass** die Stromtransformatoren (33, 34, 33n, 34n) primärseitig mit den Schaltelementen (39, 39n, 60, 60n) eine Serieschaltung bilden, und dass die Serieschaltungen zueinander, oder mit einem Bypass-Schaltelement (39b) eine Parallelschaltung bilden, und dass die elektronischen Steuermittel (41, 45, 65) so ausgelegt, und mit den Schaltelementen (39, 39n, 39b, 60, 60n) verbunden sind, dass die Schaltelemente (39, 39n, 39b, 60, 60n) alternierend und zeitweise überlappend eingeschaltet werden, und dass in Sekundärwicklungen (34, 34n) induzierte Messströme (25, 26) über die Dioden (35, 35n) oder über die sekundären monodirektionalen oder bidirektionalen Schaltelemente (61, 61n) auf den Messwiderstand (38) geführt sind, und dass Magnetisierungsströme der Stromtransformatoren (33, 34, 33n, 34n) in die Spannungs- begrenzenden Elemente (36, 36n, 37, 37n, 57, 57n) überführt werden.

12. Vorrichtung nach Anspruch 11 **dadurch gekennzeichnet, dass** die elektronischen Steuermittel (45, 65) so ausgelegt sind, dass in der Phase versetzte rechteckförmige oder sinusförmige Steuersignale (31, 32, 43, 44) erzeugt werden, und dass die Steuersignale (31, 32, 43, 44) so ausgelegt sind, dass zwei oder mehrere der seriegeschalteten monodirektionalen oder bidirektionalen Schaltelemente (39, 39b, 39n, 60, 60n) zeitweise parallel leitend sind.

13. Vorrichtung nach Anspruch 11 **dadurch gekennzeichnet, dass** eine Primärwicklung (33) des ersten Stromtransformators (33, 34) über das seriegeschaltete monodirektionale oder bidirektionale Schaltelement (39, 60) verbunden ist, und dass das monodirektionale oder bidirektionale Bypass-Schaltelement (39b) für einen direkten Nebenschluss des Stromes (22) ohne Stromtransformator vorgesehen ist, und dass die elektronischen Steuermittel (45, 65) so ausgelegt sind, dass das seriegeschaltete monodirektionale oder bidirektionale Schaltelemente (39, 60) während einer Beobachtungszeitdauer leitend geschaltet wird, und dass das monodirektionale oder bidirektionale Bypass-Schaltelement (39b) während einer Beobachtungspause leitend geschaltet wird, und dass ein vom Spannungsbegrenzenden Element (37) abgeleitetes Freigabesignal (42), Messwerte nur während der Beobachtungszeitdauer freigibt, oder dass die letzten Messwerte vor der Beobachtungspause, während der Beobachtungspause in einer vom Freigabesignal (42) gesteuerten Sample & Hold- Schaltung (41, S&H) gespeichert werden.

14. Vorrichtung nach Anspruch 13 **dadurch gekennzeichnet, dass** eine Auslöseschaltung (65, TRG) ausgelegt ist, um eine einmalige Beobachtungszeit bestimmter Dauer zu starten, wenn die Auslöseschaltung (65, TRG) über einen Triggeranschluss (66) ein externes digitales Auslösesignal (67) empfängt.

15. Vorrichtung nach Anspruch 11 **dadurch gekennzeichnet, dass** eine Oszillatorschaltung (45, OSR) eine Maximalamplitude und eine Minimalamplitude eines Colpitts- Oszillators regelt, und dass eine Resonanzfrequenz des Colpitts-Oszillators hauptsächlich von zwei Gate- Kapazitäten der seriegeschalteten monodirektionalen oder bidirektionalen Schaltelementen (39, 39b, 39n, 60, 60n) und einer die Gate- Kapazitäten verbindenden Induktivität (46) bestimmt wird, und / oder dass primärseitig eine Energie- Ernteschaltung (47-51) vorgesehen ist, bestehend aus mindestens einem Stromerntetransformator (49), welcher zu einem oder mehreren Stromtransformatoren (33, 34, 33n, 34n) seriegeschaltet ist, und aus mindestens einer Diode für Stromspeisung (48), und aus mindestens einer Diode für Spannungsspeisung (47), und dass die Energieernteschaltung (47- 51) so ausgelegt ist, dass bei ausgeschalteten seriegeschalteten monodirektionalen oder bidirektionalen Schaltelementen (39, 39b, 39n, 60, 60n) über die Dioden für Spannungsspeisung (47), und bei eingeschalteten seriegeschalteten monodirektionalen oder bidirektionalen Schaltelementen (39, 39b, 39n, 60, 60n) über den mindestens einen Stromerntetransformator (49) und die Dioden für Stromspeisung (48) Energie für den Betrieb der elektronischen Steuermittel (41, 45, 65) bereitgestellt wird.

**Claims**

1. Method for potential-isolated current measurement for power electronic circuits and electronic equipments, **characterized in that** a current to be measured (22) is uninterrupted and temporally conducted parallel over divided different paths of the current measurement (33, 39) (33n, 39n) (39b) (33, 60) (33n, 60n), and that the paths are consisting of a serial circuit of switching elements (39, 39n, 60, 60n) with primary windings (33, 33n) of current transformers (33, 34, 33n, 34n), or of a bypass switching element (39b), and that in secondary windings (34, 34n) induced secondary partial currents (25, 26) corresponding to a winding ratio of the current transformers (33, 34, 33n, 34n), to a secondary total current (29) totalised and displayed and analysed on a measurement connection (27), and that during an downtime of the switching elements (39, 39n, 60, 60n) a stored magnetic energy of the current transformer (33, 34, 33n, 34n) is discharged in voltage limiting elements (37, 37n, 57, 57n).

2. Method according to Claim 1 **characterized in that** the current to be measured (22) is divided over the primary windings (33, 33n) of the at least two current transformers (33, 34, 33n, 34n), and temporally overlapping passed trough at least two serial primary switching elements (39, 39n), and that the secondary partial currents (25, 26) are conducted through diodes (35, 35n) in current direction and added on a measuring resistor (38), and that the stored magnetic energy of the current transformers (33, 34, 33n, 34n) is discharged during the downtime in voltage limiting elements (37, 37n, 57, 57n) through diodes (36, 36n) in blocking direction of the secondary partial currents (25, 26).

3. Method according to Claim 2 **characterized in that** the serial switching elements (39, 39n) are switched with a soft switching characteristic, preferred with a resonant characteristic.

4. Method according to Claim 3 **characterized in that** the serial switching elements (39, 39n) are controlled with individual phase shifted sinusoidal signals (43, 44), in which the amplitude of the sinusoidal signals has such a minimal value and such a maximal value that the serial switching elements (39, 39n) are transferred in the conductive state with a certain overlapping.

5. Method according to Claim 2 **characterized in that** the current to be measured (22) is bidirectional, and that serial primary bidirectional switching elements (60, 60n) can conduct current bidirectional, und that instead of diodes (35, 35n) in current direction secondary bidirectional switching elements (61, 61n) conduct the secondary partial currents (25, 26) to the measuring resistor (38), and that the secondary bidirectional switching elements (61, 61n) are switched synchronously with the corresponding serial primary bidirectional switching elements (60, 60n), and that the voltage limiting elements (37, 37n, 57, 57n) acts bidirectional for the discharge of the magnetic circuits.

6. Method according to Claim 2 **characterized in that** the current to be measured (22) is mono-directional, and that the serial switching elements (39, 39n) are designed for one current direction only.

7. Method according to Claim 2 **characterized in that** a compensating circuit (56, RCP) generates a ramp-shaped signal that way synchronous between the downtimes and adds the ramp-shaped signal to a signal on the measurement connection (27) that an error caused by a magnetisation current is directly compensated.

8. Method according to Claim 2 **characterized in that** for a measuring range expansion can be switched to the measuring resistor (38) at least one additional measuring resistor (53) by at least one range-selection switching element (54).

9. Method according to Claim 1 **characterized in that** the current to be measured (22) during a certain observation period is passed through the primary winding (33) of the first current transformer (33, 34) and the first serial switching element (39), and that during a observation pause period the current to be measured (22) is passed direct and without measurement trough the bypass switching element (39b), and that the measurement is evaluated only during the observation period, or the last measurement of the observation period is retained during the observation pause period.

10. Method according to Claim 9 **characterized in that** the observation period is triggered by a superior system, and that statistical values of the current to be measured (22) are provided from several observation periods, or that the current to be measured (22) is multiple-sampled during the observation period by the superior system in order to build up the statistical values.

11. Device for potential-isolated measurement of continuous or alternate current (22) having current transformers (33, 34, 33n, 34n) and mono-directional or bidirectional switching elements (39, 39n, 39b, 60, 60n, 61, 61n) and electronic control means (41, 45, 65) and diodes (35, 35n) and voltage limiting elements (36, 36n, 37, 37n, 57, 57n) and a measuring resistor (38), **characterized in that** the current transformers (33, 34, 33n, 34n) forms primary side a serial connection with the switching elements (39, 39n, 60, 60n), and that the serial connections together, or with a bypass switching element (39b) forms a parallel connection, and that the electronic control means (41, 45, 65) are designed, and connected with the switching elements (39, 39n, 39b, 60, 60n), that the switching elements (39, 39n, 39b, 60, 60n) are alternated and intermittent overlapping switched on, and that in secondary windings (34, 34n) induced measuring currents (25, 26) are passed through diodes (35, 35n) or through the secondary mono-directional or bidirectional switching elements (61, 61n) to the measuring resistor (38), and that magnetic currents of the current transformers (33, 34, 33n, 34n) are passed to the voltage limiting elements (36, 36n, 37, 37n, 57, 57n).

12. Device according to Claim 11 **characterized in that** the electronic control means (45, 65) are designed to generate phase shifted rectangular or sinusoidal control signals (31, 32, 43, 44), and that the control signals (31, 32, 43, 44) are designed that two or more of the serial connected mono-directional or bidirectional switching elements (39, 39b, 39n, 60, 60n) are temporarily parallel conducting.

13. Device according to Claim 11 **characterized in that** a primary winding (33) of the first current transformer (33, 34) is connected through the serial mono-directional or bidirectional switching element (39, 60), and that the mono-directional or bidirectional bypass switching element (39b) is provided for a direct bypass of the current (22) without a current transformer, and that the electronic control means (45, 65) are designed that the mono-directional or bidirectional switching element (39, 60) becomes conducting during an observation period, and that the mono-directional or bidirectional bypass switching element (39b) becomes conducting during an observation rest period, and that derived from the voltage limiting element (37), an enabling signal (42) releases the measured values only during the observation period, or that controlled by the enabling signal (42), the last measured values before the observation pause period are stored during the observation pause period in a Sample & Hold-circuit (41, S&H).

14. Device according to Claim 13 **characterized in that** a trigger circuit (65, TRG) is designed, to start a one-time observation period of certain length, if the trigger circuit (65, TRG) receives an external digital activating signal (67) to a trigger connection (66).

15. Device according to Claim 11 **characterized in that** an oscillator circuit (45, OSR) controls a maximum and a minimum amplitude of a Colpitts oscillator, and that a resonance frequency of the Colpitts oscillator is mainly set by two Gate-capacitances of the serial mono-directional or bidirectional switching elements (39, 39b, 39n, 60, 60n) and an inductance (46) connected between the Gate capacitances, and / or that on the primary side an energy-harvesting circuit (47-51) is provided, composed of at least a current harvesting transformer (49), which is serial connected to one or more current transformers (33, 34, 33n, 34n), and of at least one diode for current sourcing (48), and of at least one diode for voltage sourcing (47), and that the energy-harvesting circuit (47-51) is designed that at switched off serial mono-directional or bidirectional switching elements (39, 39b, 39n, 60, 60n) energy is supplied to the electronic control means (41, 45, 65) through the diodes for voltage sourcing (47), and at switched on serial mono-directional or bidirectional switching elements (39, 39b, 39n, 60, 60n) energy is supplied to the electronic control means (41, 45, 65) through the at least one current harvesting transformer (49) and the diodes for current sourcing (48).

**Revendications**

1. Procédé de mesure du courant isolé galvaniquement pour des circuits électroniques de puissance et pour des équipements électriques, **caractérisé en ce que** un courant à mesurer (22) étant conduit sans interruption et temporairement divisé à travers des branches en parallèles de la mesure du courant (33, 39) (33n, 39n) (39b) (33, 60) (33n, 60n), et **en ce que** les branches sont constitués d'une mise en série des éléments de commutation (39, 39n, 60, 60n) avec des enroulements primaires (33, 33n) des transformateurs de courant (33, 34, 33n, 34n), ou d'un élément de commutation by-pass (39b), et **en ce que** des courants partial secondaires (25, 26) induit dans des enroulements secondaires (34, 34n) selon d'un rapport de transformation des transformateurs (33, 34, 33n, 34n), sont additionné et représenté en forme d'un courant totale secondaire (29) et reproduit dans une connexion de mesure (27), et **en ce que** durant des temps d'interruptions des éléments de commutation (39, 39n, 60, 60n), une énergie magnétique accumulée dans les transformateurs de courant (33, 34, 33n, 34n) étant déchargée dans des éléments de tension limité (37, 37n, 57, 57n).

2. Procédé selon la revendication 1, **caractérisé en ce que** le courant à mesurer (22) étant divisé et conduit temporairement superposé par les enroulements primaires (33, 33n) des d'au moins deux transformateurs de courant (33, 34, 33n, 34n), et des d'au moins deux éléments de commutation branché en série (39, 39n), et **en ce que** les courants partial secondaires (25, 26) sont fourni par des diodes (35, 35n) dans le sens de courant et additionnés moyennant par une résistance de mesure (38), et **en ce que** l'énergie magnétique accumulé dans les transformateurs de courant (33, 34, 33n, 34n) étant déchargé durant le temps d'interruptions par des diodes (36, 36n) dans le sens de blocage des courants partial secondaires (25, 26) dans les éléments de tension limité (37, 37n, 57, 57n).

3. Procédé selon la revendication 2, **caractérisé en ce que** les éléments de commutation branché en série (39, 39n) étant commuté avec une caractéristique doux, étant de préférence une caractéristique résonante.

4. Procédé selon la revendication 3, **caractérisé en ce que** les éléments de commutation branché en série (39, 39n) sont contrôlé par des signaux sinusoïdal avec déphasage individuelle (43, 44), possédant une telle valeur minimal e une telle valeur maximal d'amplitude des signaux sinusoïdal, **en ce que** les éléments de commutation branché en série (39, 39n) sont mise en état conductrice avec un certain degré de recouvrement.

5. Procédé selon la revendication 2, **caractérisé en ce que** le courant à mesurer (22) étant bidirectionnel, et des éléments de commutation bidirectionnel branché en série (60, 60n) étant capable de conduire le courant bidirectionnel, et **en ce que** au lieu des diodes (35, 35n) dans le sens de courant, sont prévu des éléments bidirectionnel secondaire (61, 61n) lesquels conduits les courants partial secondaires (25, 26) vers la résistance de mesure (38), et **en ce que** les éléments bidirectionnel secondaire (61, 61n) sont commutés en synchronisme avec les correspondants éléments de commutation bidirectionnel branché en série (60, 60n), et **en ce que** les éléments de limitation de tension (37, 37n, 57, 57n) pour la décharge des circuits magnétique sont prévue pour le service bidirectionnel.

6. Procédé selon la revendication 2, **caractérisé en ce que** le courant à mesurer (22) étant monodirectionnel et les éléments de commutation branché en série (39, 39n) étant prévue pour une seule direction de courant.

7. Procédé selon la revendication 2, **caractérisé en ce que** un circuit de compensation (56, RCP) génère un signal d'une fonction de rampe synchrone entre le temps d'interruptions et l'addition à un signal de la connexion de mesure (27), **en ce que** une erreur provoqué d'un courant de magnétisation étant juste compensé.

8. Procédé selon la revendication 2, **caractérisé en ce que** d'au moins une résistance additionnel (53) étant connecté a la résistance de mesure (38) d'au moins un élément de commutation pour la plage de mesure (54) pour permettre une extension de la plage de mesure.

9. Procédé selon la revendication 1, **caractérisé en ce que** le courant à mesurer (22) durant une certain période d'observation étant branché en série par l'enroulement primaire (33) du première transformateur de courant (33, 34) et du première élément de commutation branché en série (39), et **en ce que** durant une période sans observation le courant à mesurer (22) étant conduit direct et sans mesurer par l'élément de commutation by-pass (39b), et **en ce que** la mesure étant exploité seulement durant la période d'observation, ou la dernière valeur de mesure de la période d'observation étant maintenu durant la période sans observation.

10. Procédé selon la revendication 9, **caractérisé en ce que** l'activation de la période d'observation étant activé par un système superposé, et **en ce que** des valeurs statistique du courant à mesurer (22) étant constitué de plusieurs périodes d'observation, ou **en ce que** le courant à mesurer (22) étant balayés plusieurs fois du système superposé durant la période d'observation.

11. Dispositif de mesure du courant isolé galvaniquement pour courant continue ou courant alternatif (22) constitué en transformateurs de courant (33, 34, 33n, 34n) et en éléments de commutation monodirectionnel ou bidirectionnel (39, 39n, 39b, 60, 60n, 61, 61n) et en dispositifs électroniques (41, 45, 65) et en diodes (35, 35n) et en éléments de tension limité (36, 36n, 37, 37n, 57, 57n) et une résistance de mesure (38), **caractérisé en ce que** les transformateurs de courant (33, 34, 33n, 34n) sont branchés en série au circuit primaire avec les éléments de commutation (39, 39n, 60, 60n), et **en ce que** les branches entre eux, ou un élément de commutation by-pass (39b) sont branché en parallèle, et **en ce que** les dispositifs électroniques (41, 45, 65) étant disposés et branché avec les éléments de commutation (39, 39n, 39b, 60, 60n), de manière que les éléments de commutation (39, 39n, 39b, 60, 60n) étant activé en alternance et temporairement superposé, et **en ce que** les courants de mesure (25, 26) induit dans des enroulements secondaires (34, 34n) sont fourni par les diodes (35, 35n) ou par les éléments de commutation monodirectionnel ou bidirectionnel secondaires (61, 61n) à la résistance de mesure (38), et **en ce que** les courants de magnétisation des transformateurs de courant (33, 34, 33n, 34n) étant transférer a les éléments de tension limité (36, 36n, 37, 37n, 57, 57n).

12. Dispositif de mesure du courant isolé galvaniquement selon la revendication 11, **caractérisé en ce que** les dispositifs électroniques (45, 65) sont prévues pour généré des signaux de contrôle déphasés de forme rectangulaire ou sinusoïdal (31, 32, 43, 44), et **en ce que** les signaux de contrôle (31, 32, 43, 44) sont conçu **en ce que** deux ou plusieurs des éléments de commutation monodirectionnel ou bidirectionnel branché en série (39, 39b, 39n, 60, 60n), conduisent temporairement en parallèle.

13. Dispositif de mesure du courant isolé galvaniquement selon la revendication 11, **caractérisé en ce que** un enroulement primaire (33) du premier transformateur de courant (33, 34) étant connecté avec l'élément de commutation monodirectionnel ou bidirectionnel branché en série (39, 60), et **en ce que** l'élément de commutation by-pass monodirectionnel ou bidirectionnel (39b) étant conçu pour un by-pass direct du courant (22) sans transformateur de courant, et **en ce que** les dispositifs électroniques (45, 65) étant conçu **en ce que** l'élément de commutation monodirectionnel ou bidirectionnel branché en série (39, 60) étant conduisant durant une période d'observation, et **en ce que** le l'élément de commutation by-pass monodirectionnel ou bidirectionnel (39b) étant conduisant durant une période sans observation, et **en ce que** un signal d'activation (42) dérivé de l'élément de tension limité (37) laisse passer les résultats de mesure seulement durant la période d'observation, ou **en ce que** les dernières résultats de mesure avant la période sans observation, sont maintenu dans un circuit Sample & Hold (41, S&H) durant la période d'observation contrôlé du signal d'activation (42).

14. Dispositif de mesure du courant isolé galvaniquement selon la revendication 13, **caractérisé en ce que** un circuit de déclanchement (65, TRG) est conçu pour faire partir une unique période d'observation de certain duré quand le circuit de déclanchement (65, TRG) reçoit un signal digital externe de déclanchement (67) par une connexion de déclanchement (66).

15. Dispositif de mesure du courant isolé galvaniquement selon la revendication 11, **caractérisé en ce que** un circuit oscillateur (45, OSR) possède des dispositifs pour régler une amplitude maximal et une amplitude minimal d'un oscillateur de Colpitts, et **en ce que** une fréquence de résonance du circuit oscillateur de Colpitts étant principalement déterminé par deux capacités de grille des éléments de commutation monodirectionnel ou bidirectionnel branché en série (39, 39b, 39n, 60, 60n) et une inductance (46) interconnecté des capacités de grille, et / ou **en ce que** étant disposé parte primaire un circuit de récolte d'énergie (47-51), constitué d'au moins d'un transformateur de récolte d'énergie (49), lequel étant branché en série d'un ou plusieurs transformateurs de courant (33, 34, 33n, 34n), et d'au moins d'une diode d'alimentation de courant (48), et d'au moins d'une diode d'alimentation de tension (47), et **en ce que** le circuit de récolte d'énergie (47- 51) étant disposé **en ce que** l'énergie étant mis à disposition de service des dispositifs électroniques (41, 45, 65) durant les éléments de commutation monodirectionnel ou bidirectionnel branché en série (39, 39b, 39n, 60, 60n) sont coupé, par les diode d'alimentation de tension (47), et durant les éléments de commutation monodirectionnel ou bidirectionnel branché en série (39, 39b, 39n, 60, 60n) sont mise en circuit, par d'au moins l'un transformateur de récolte d'énergie (49) et la diode d'alimentation de courant (48).

21 22 23 35 25 36 37 24 33n 35n 26 29 27

33

31

30 22 39 34 32 39n 34n 37n 36n 38 28

Fig 1

II

a

8 10 1 13

6 2

R₁ R₂

7 3 14

4 9 11 5

II

Fig 2 Prior Art

21 33 34 35 36 37 33n 35n 36n 38 27

30 39 40 39n 34n 37n 28

Fig 3

21 33 34 35 36 37 42 38 41 28 27

31

S&H

TRG

30 39 40 32 39b 69 68 65 67 66

Fig 4

Fig 5

Fig 6

Fig 7

Fig 8

Fig 9a

Fig 9b

Fig 10a

Fig 10b

Fig 11a

Fig 11b

Fig 11c

Fig 12

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3405442, Bühler
- US 5815391 A, Pelly
- US 5196784 A, Estes
- US 20090015184 A, Knierim
- US 1624537 A